(19)

Europäisches
Patentamt
European
Patent Office
Office européen
des brevets

(11) **EP 4 386 832 B1**

(12) **EUROPEAN PATENT SPECIFICATION**

(45) Date of publication and mention
of the grant of the patent:
**19.11.2025 Bulletin 2025/47**

(21) Application number: **23180389.1**

(22) Date of filing: **20.06.2023**

(51) International Patent Classification (IPC):
**H01L 23/427** (2006.01)      **H01L 25/065** (2023.01)

(52) Cooperative Patent Classification (CPC):
**H01L 23/427; H01L 25/0657;** H01L 2225/06589

(54) **SEMICONDUCTOR DEVICE HAVING TWO-PHASE COOLING STRUCTURE**

HALBLEITERANORDNUNG MIT ZWEIPHASIGER KÜHLSTRUKTUR

DISPOSITIF SEMI-CONDUCTEUR AYANT UNE STRUCTURE DE REFROIDISSEMENT À DEUX
PHASES

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **16.12.2022 KR 20220177330**

(43) Date of publication of application:
**19.06.2024 Bulletin 2024/25**

(73) Proprietor: **Samsung Electronics Co., Ltd.
Suwon-si, Gyeonggi-do 16677 (KR)**

(72) Inventors:
• **KANG, Sungchan
Suwon-si, 16678 (KR)**

• **SON, Daehyuk
Suwon-si, 16678 (KR)**
• **HONG, Seogwoo
Suwon-si, 16678 (KR)**

(74) Representative: **Elkington and Fife LLP
Prospect House
8 Pembroke Road
Sevenoaks, Kent TN13 1XR (GB)**

(56) References cited:
**US-A1- 2005 139 996      US-A1- 2005 280 162
US-A1- 2010 187 683      US-A1- 2018 294 205
US-B1- 6 698 502**

**Description**

FIELD OF THE INVENTION

The disclosure relates to a semiconductor device having a two-phase cooling structure.

BACKGROUND OF THE INVENTION

In order to remove heat generated by operation of electronic devices, an air-cooling device has been mainly used. As the power density of electronic devices has gradually increased, the use of liquid cooling devices is increasing to cope with the increase in heat generation. Moreover, in the case of a data center, in order to reduce the amount of power used, interest in a next-generation cooling method with high efficiency, such as a liquid cooling device, is gradually increasing. Depending on a temperature range of a part where heat is generated, liquid cooling methods may be classified into single-phase liquid cooling methods without a phase change of a coolant and two-phase liquid cooling methods involving a phase change of a coolant. The two-phase liquid cooling method has a higher calorific value range than the single-phase liquid cooling method.

US 2005/280162 A1 describes a thermal interposer for attachment to the back surface of a semiconductor device so as to give a very low thermal resistance.

US 2018/294205 A1 describes techniques for wafer level integration of embedded cooling structures for integrated circuit devices.

US 2010/187683 A1 describes three dimensional integrated circuits with double sided power, coolant, and data features.

US 2005/139996 A1 describes a method for integrating an electro-osmotic pump and a microchannel cooling assembly.

US 6698502 B1 describes a cooling device having a high cooling efficiency in a miniature size that is neither influenced by gravity nor restricted in its position of installation.

SUMMARY OF THE INVENTION

Provided is a semiconductor device implementing a two-phase cooling method.

Provided is a semiconductor device implementing a two-phase cooling structure capable of coping with a decrease in cooling efficiency due to vapor adsorption to a heating surface.

Additional aspects will be set forth in part in the description which follows and, in part, will be apparent from the description, or may be learned by practice of the presented embodiments of the disclosure.

According to an aspect of the disclosure, there is provided a semiconductor device according to claim 1.

An entirety of the cooling channel may be formed inside the semiconductor chip.

At least first portion of cooling channel is formed inward from an upper surface of the semiconductor chip.

The first fine pattern is configured to generate a capillary force that moves the liquid coolant in the transverse direction along the first wall surface and the second fine pattern may be configured to generate a capillary force that moves the liquid coolant in the longitudinal direction along the second wall surface and to the first wall surface.

The semiconductor device may include a package housing at least partially surrounding the semiconductor chip, where the package housing may include a first opening configured to discharge the gaseous coolant from the cooling channel and a second opening configured to supply the liquid coolant to the cooling channel.

The semiconductor device may include a supply channel provided on an upper surface of the semiconductor chip and connecting the second opening to the cooling channel.

The supply channel may include a third fine pattern on the upper surface of the semiconductor chip and configured to generate a capillary force that moves the liquid coolant.

A plurality of cooling channels, including the cooling channel, may be provided in the semiconductor chip and where a plurality of first openings respectively corresponding to the plurality of cooling channels are provided in the package housing.

The semiconductor device may include a plurality of semiconductor chips stacked in a longitudinal direction and each including the cooling channel, where each of the plurality of semiconductor chips other than a lowest semiconductor chip of the plurality of semiconductor chips may include a connection channel penetrating in the longitudinal direction.

The connection channel may include a wall surface including second fine pattern extending in the longitudinal direction.

The semiconductor device may include outer cooling channel between two adjacent semiconductor chips of the plurality of semiconductor chips, and a first fine pattern configured to generate a capillary force that moves the liquid coolant in a transverse direction may be provided on at least a portion of a wall surface of the outer cooling channel in the transverse direction.

The first fine pattern may be provided on an upper surface of a lower semiconductor chip of two adjacent semiconductor chips of the plurality of semiconductor chips.

BRIEF DESCRIPTION OF DRAWINGS

The above and other aspects, features, and advantages of certain embodiments of the disclosure will be more apparent from the following description taken in conjunction with the accompanying drawings, in which:

FIG. 1 is a diagram of a semiconductor device according to an embodiment;

FIG. 2 is a diagram of a cooling channel in FIG. 1 according to an embodiment;

FIG. 3 is a diagram of a semiconductor device according to an embodiment;

FIGS. 4A, 4B and 4C are diagrams showing various examples of a first fine pattern according to an embodiment;

FIGS. 5A, 5B, 5C and 5D are diagrams showing various examples of a cooling channel and a second fine pattern according to an embodiment;

FIG. 6 is a diagram of a semiconductor device according to an embodiment;

FIG. 7 is a diagram of a semiconductor device according to an embodiment;

FIG. 8 is a diagram of a semiconductor chip shown in FIG. 7 according to an embodiment;

FIG. 9 is a diagram of a semiconductor device according to an embodiment;

FIG. 10 is a diagram of a semiconductor device according to an embodiment;

FIG. 11 is a diagram of a semiconductor device according to an embodiment;

FIG. 12 is a diagram of a semiconductor device according to an embodiment;

FIG. 13 is a diagram of a semiconductor device according to an embodiment;

FIG. 14 is a diagram of a semiconductor device according to an embodiment;

FIGS. 15A and 15B are diagrams an example of an apparatus for verifying the effect of a semiconductor device according to an embodiment; and

FIG. 16 is a graph showing the results of experiments performed using the apparatus of FIGS. 15A and 15B according to an embodiment.

DETAILED DESCRIPTION

Reference will now be made in detail to embodiments, examples of which are illustrated in the accompanying drawings, wherein like reference numerals refer to like elements throughout. In this regard, some embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, embodiments will be described in detail with reference to the accompanying drawings. Like reference numerals in the drawings denote like components, and sizes of components in the drawings may be exaggerated for convenience of explanation. In addition, embodiments to be described below are only exemplary and various modifications from such embodiments may be possible. Hereinafter, the term "on" or "above" may include not only one directly above another in contact but also one directly above another without contact. Singular expressions include plural expressions unless they are explicitly and differently specified in context. In addition, when a portion includes a component, a case may mean further including other components without excluding other components unless otherwise described. The use of the term "above" and similar indicative terms may correspond to both singular and plural. When there is no explicit description or contrary description of operations constituting a method, these operations may be performed in an appropriate order, and may not be necessarily limited to the described order. Also, in the specification, the term "units" or "...modules" denote units or modules that process at least one function or operation, and may be realized by hardware, software, or a combination of hardware and software. Connections of lines between components or connection members illustrated in the drawings exemplarily represent functional connection and/or physical or circuitry connections, and in a real apparatus, may be implemented by replaceable or additional various functional connections, physical connections, or circuitry connections.

An efficient cooling system is required to solve a cooling problem that has been a limiting factor in the performance of electronic devices including semiconductor chips. In the case of high performance computing (HPC) fields and semiconductor devices to which stacked three-dimensional semiconductor chips are applied, a cooling system capable of responding to an increase in power density and an increase in heat generation due to high integration is required. In order to meet these demands, a two-phase liquid cooling system capable of utilizing latent heat of vaporization of a coolant may be applied to a semiconductor device. The two-phase liquid cooling method may include immersion cooling, spray cooling, and jet impingement cooling.

The immersion cooling is a widely used method of cooling an electronic device to be cooled by immersing it in a bath containing a liquid coolant. Because the entire electronic device is needed to be immersed in a liquid coolant, the usable coolant is limited to a dielectric coolant. Therefore, this method requires high management costs and is not environmentally friendly. In addition, the vapor of the coolant is adsorbed to a heating surface of the electronic device, thereby reducing cooling efficiency. In a boiling graph, this phenomenon is called critical heat flux (CHF). It is necessary to improve the CHF to cool a larger heat flux.

The spray cooling is a method of atomizing a liquid coolant and spraying the coolant on a heating surface and has high cooling efficiency compared to the amount of liquid coolant used. However, a spray cooling device requires a pumping device capable of operating at high pressure and requires continuous maintenance of spray nozzles. In addition, when a film boiling phenomenon in which vapor of the coolant is adsorbed to a heating surface occurs, the vapor prevents heat transfer from the heating surface to the coolant, thereby reducing cooling efficiency.

The jet impingement cooling is a cooling method in which a liquid coolant is injected to a heating surface at a high speed. It shows high cooling efficiency like the spray cooling method but has a disadvantage of requiring several injectors to evenly cool the heating surface, and in addition, even if several injectors are used, there may be a blind area where the jet of liquid coolant does not reach.

According to a two-phase liquid cooling system of the disclosure, at least a portion of a cooling channel serving as a passage of a coolant is formed inside an object to be cooled. In other words, the cooling channel may be formed entirely inside the object to be cooled. Specifically, the cooling channel may be formed inward from the surface (e.g., upper surface) of the object to be cooled. The object to be cooled may be, for example, a semiconductor chip (integrated circuit die). The cross-sectional area of the cooling channel may include a liquid passage area provided with a fine pattern forming capillary force to allow a liquid coolant to flow, and a gas passage area having no capillary structure to allow a gaseous coolant to flow. The liquid passage area and the gas passage area are not physically separated areas, but are distinguished by the presence or absence of a fine pattern. In the liquid passage area, the liquid coolant absorbs heat from a heating surface adjacent to a heating source and vaporizes to be vapor. According to the disclosure, vapor generated in the liquid passage area is moved to the gas passage area and may be discharged to the outside of the cooling object (i.e., the object to be cooled) along the gas passage area. The liquid coolant is filled, by the capillary force, in an area where vapor escapes from the liquid passage area. According to this configuration, because vapor is easily released from the heating surface, cooling efficiency may be improved and generation of hot spots may be reduced or prevented. In addition, the fine pattern increases a heat exchange area with the liquid coolant, thereby facilitating heat exchange with the heat source. In addition, because the liquid coolant flows along the liquid passage area by the capillary force, a coolant supply unit such as a high-capacity pump for supplying the liquid coolant to the cooling channel may not be required, thereby reducing the price of the cooling system and reducing power consumption.

In the following description, a first direction X denotes one of directions parallel to an upper surface of the semiconductor chip. A second direction Z denotes a thickness direction of the semiconductor chip. A third direction Y denotes a direction orthogonal to the first direction X from among the directions parallel to the upper surface of the semiconductor chip.

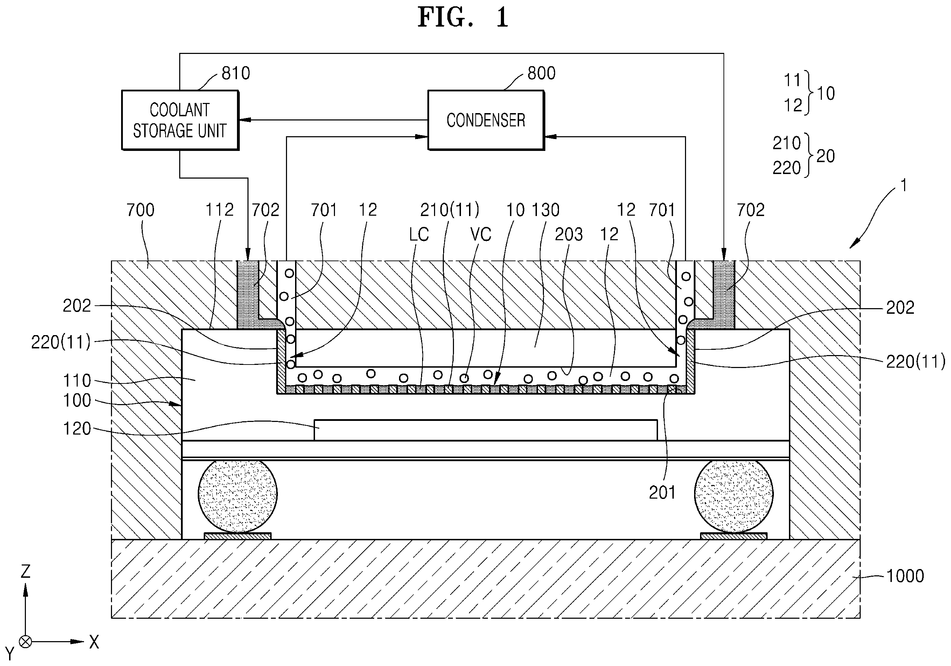

FIG. 1 is a diagram of a semiconductor device 1 according to an embodiment. Referring to FIG. 1, the semiconductor device 1 according to an embodiment may include a semiconductor chip 100 and a cooling channel 10.

The semiconductor chip 100 may include a substrate 110 and a semiconductor integrated circuit 120 formed on one surface of the substrate 110. The semiconductor chip 100 may be various semiconductor integrated circuit chips. For example, the semiconductor chip 100 may be a memory chip including a memory integrated circuit, a logic chip including a logic integrated circuit, a central processing unit (CPU) chip, a graphic processing unit (GPU) chip, an application specific integrated circuit (ASIC) chip, or the like. In order to implement the semiconductor device 1 of a small form factor, the semiconductor chip 100 may be a wafer-level semiconductor integrated circuit chip. The substrate 110 may be a wafer. The semiconductor chip 100 may be mounted on a printed circuit board 1000 by, for example, solder balls. A wiring layer for electrical connection between the semiconductor integrated circuit 120 and the printed circuit board 1000 may be provided on a lower surface of the semiconductor chip 100. The wiring layer is electrically passivated to the outside. The semiconductor chip 100 may be referred to as an integrated circuit die, and the semiconductor device 1 including the integrated circuit die may be referred to as an integrated circuit device.

A two-phase liquid cooling structure may include the cooling channel 10. At least a portion(first portion) of the cooling channel 10 is formed inside the semiconductor chip 100, for example, inside the substrate 110. In other words, the cooling channel 10 may be formed inside the semiconductor chip 100 as a whole, for example, inside the substrate 110 and communicate with the outside, and may be formed inward from an upper surface of the semiconductor chip 100, for example, an upper surface 112 of the substrate 110. At least a portion of the wall surface of the cooling channel 10 is provided with a fine pattern 20 that generates a capillary force that causes a liquid coolant LC to flow. As a result, a passage (i.e., a liquid channel area 11) of the liquid coolant LC is formed in a region(first area) of the cooling channel 10 where the fine pattern 20 is formed, and a passage (i.e., a gas channel area 12) of a gaseous coolant VC is formed in the remaining region(second area) of the cooling channel 10 where a capillary structure (i.e., the fine pattern 20) is not formed. The cooling channel 10 may be connected to a condenser 800 and a coolant storage unit 810. In this way, a two-phase liquid cooling system may be implemented. The coolant storage unit 810 may be omitted and the condenser 800 may also function as the coolant storage unit 810.

According to the disclosure, in the semiconductor chip 100, the cooling channel 10 is formed to have the liquid channel area 11 through which the liquid coolant LC moves, and the gas channel area 12 that communicates with the liquid channel area 11 and moves the gaseous coolant VC. In other words, a cross-sectional area of the cooling channel 10 includes a liquid channel area 11 and a gas channel area 12. The liquid coolant LC from the coolant storage unit 810 is effectively moved into the semiconductor chip 100 along the liquid channel area 11 by the capillary force generated by the fine pattern 20 in the cooling channel 10. The liquid coolant LC in the liquid channel area 11 absorbs heat from a heat source of the semiconductor chip 100 (for example, the semiconductor integrated circuit 120) and vaporizes to be the gaseous coolant VC. The gaseous coolant VC moves from the liquid channel area 11 to the gas channel area 12. The liquid coolant LC fills, by the capillary force, a space where the gaseous coolant VC escapes from the liquid channel area 11. The gaseous coolant VC is moved to the condenser 800 along the gas channel area 12. The gaseous coolant VC is phase-changed to a liquid coolant LC in the condenser 800, and then the liquid coolant LC is transferred to the coolant storage unit 810.

With this configuration, because the liquid coolant LC may be supplied to a location close to the heat source inside the semiconductor chip 100, the semiconductor chip 100 may be effectively cooled. When the liquid coolant LC vaporizes near the heat source, the gaseous coolant VC escapes into the gas passage area 12, and an empty space of the liquid passage area 11, from which the gaseous coolant VC escapes, is quickly filled by the liquid coolant LC introduced from the surroundings by the capillarity of the fine pattern 20. The gaseous coolant VC is moved to the condenser 800 through the gas channel area 12. Therefore, because the liquid coolant LC may be quickly and continuously supplied around the heat source, thermal resistance near the heat source may be reduced. In other words, the formation of a vapor film on the surface of the cooling channel 10 near the heat source may be reduced or eliminated, and thus, the cooling performance may be uniformly maintained.

In addition, the generation of hot spots may be suppressed and heat may be effectively dissipated. In addition, because the liquid coolant LC is moved by the capillary force generated by the fine pattern 20, a pump or the like for moving the liquid coolant LC may be omitted, thereby reducing the power consumption of the cooling system. Because the area of a heat transfer surface is increased by the fine pattern 20, heat transfer efficiency from the semiconductor chip 100 to the coolant may be improved, and vapor of the gaseous coolant VC may be effectively removed from the heat transfer surface to thereby improve critical heat flux (CHF) performance. In addition, because the liquid coolant LC is moved by the capillary force, the liquid coolant LC is not affected by the posture of the semiconductor device 1. In other words, even when the semiconductor device 1 (i.e., the integrated circuit device) shown in FIG. 1 is applied to an electronic device in an upright or upside down state, the liquid channel area 11 and the gas channel area 12 remain intact, and the liquid coolant LC is moved along the liquid channel area 11 and the gaseous coolant VC moves along the gas channel area 12.

Also, according to the disclosure, the cooling channel 10 and the fine pattern 20 are formed in the semiconductor chip 100 (for example, in the substrate 110). The substrate 110 is a wafer in which the semiconductor integrated circuit 120 is formed by a semiconductor process. After the semiconductor integrated circuit 120 is formed in one surface of the substrate 110 (for example, the lower surface (or active surface) of the substrate 110) by a semiconductor process, the cooling channel 10 may be formed inward from the other surface of the substrate 110 (for example, the upper surface (or inactive surface) 112 of the substrate 110) by a semiconductor process such as etching. In addition, the fine pattern 20 may be formed in at least a portion of a wall surface of the cooling channel 10 by a semiconductor process such as etching or laser ablation. In this way, a structure for cooling may be formed in a process of manufacturing the semiconductor chip 100, and thus, the semiconductor device 1 having a cooling structure may be easily manufactured.

The liquid coolant LC is moved along the liquid channel area 11 by the capillary force generated by the fine pattern 20. The liquid coolant LC may not be present in the gas channel area 12. Accordingly, the gaseous coolant VC may be effectively discharged to the outside of the semiconductor chip 100 along the gas channel area 12. However, the liquid coolant LC may also be partially present in the gas channel area 12 due to disturbance such as vibration.

As an example, referring to FIG. 1, the cooling channel 10 is formed inside the semiconductor chip 100, for example, inside the substrate 110. The wall surface of the cooling channel 10 may include a first wall surface 201, a second wall surface 202, and a third wall surface 203. The first wall surface 201 is a wall surface in a transverse direction, which is formed inward from the upper surface of the semiconductor chip 100 (for example, the upper surface 112 of the substrate 110) and is close to the semiconductor integrated circuit 120. In other words, the first wall surface 201 is the bottom surface of the cooling channel 10. The second wall surface 202 is a side wall surface extending in a longitudinal direction from the first wall surface 201 toward the upper surface 112 of the substrate 110. The third wall surface 203 is a wall surface in a transverse direction facing the first wall surface 201 (i.e., a ceiling surface). The third wall surface 203 may be the lower surface of a cover 130 covering an upper portion of the cooling channel 10. The transverse direction is a direction parallel to the upper surface 112 of the substrate 110 and may refer to a first direction X and/or a third direction Y. The fine pattern (wick pattern) 20 that generates capillary force is formed on at least some of the wall surfaces of the cooling channel 10 (for example, the first, second, and third wall surfaces 201, 202, and 203). A first fine pattern (first wick pattern) 210 is provided on the first wall surface 201 and a second fine pattern (second wick pattern) 220 is provided on the second wall surface 202. A fine pattern (for example, the first fine pattern 210) may also be provided on the third wall surface 203. The capillary force acts as a flow pressure that causes the liquid coolant LC to flow. The first fine pattern 210 is a wick pattern in the transverse direction, which is provided on the first wall surface 201 that is a wall surface of the cooling channel 10 in the transverse direction. The first fine patterns 210 generate capillary force to move the liquid coolant LC in the transverse direction along the first wall surface 201. The second fine pattern 220 is a wick pattern in the longitudinal direction, which is provided on the second wall surface 202 that is a wall surface of the cooling channel 10 in the longitudinal direction. The second fine pattern 220 generate capillary force to move the liquid coolant LC in the longitudinal direction along the second wall surface 202 and supply the liquid coolant LC to the first wall surface 201. The liquid coolant LC is moved toward the first wall surface 201 along the second wall surface 202 by the second fine pattern 220. Exemplary shapes of the first fine pattern 210 and the second fine pattern 220 are described below.

The cooling channel 10 is connected to the condenser 800 and the coolant storage unit 810. For example, the semiconductor chip 100 is packaged by a package housing 700. The package housing 700 surrounds the semiconductor chip 100. The package housing 700 may at least partially surround the semiconductor chip 100. The package housing 700 has a first opening 701 through which the gaseous coolant VC is discharged from the cooling channel 10, and a second opening 702 for supplying the liquid coolant LC to the cooling channel 10. The first opening 701 is an outlet through which the gaseous coolant VC is discharged from the cooling channel 10, and the second opening 702 is an inlet for supplying the liquid coolant LC to the cooling channel 10. The first opening 701 is connected to the condenser 800. The second opening 702 is connected to the coolant storage unit 810. When the condenser 800 also functions as the coolant storage unit 810, the first and second openings 701 and 702 are connected to the condenser 800.

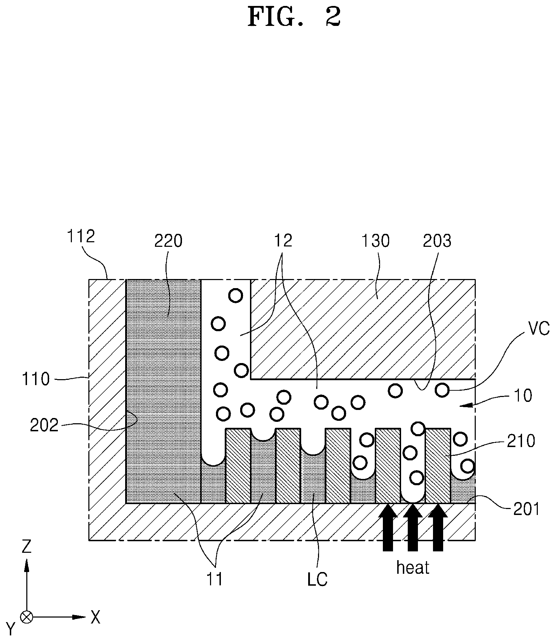

FIG. 2 is a diagram of a cooling channel in FIG. 1 according to an embodiment. That is, FIG. 2 is a detailed view of the cooling channel 10 in FIG. 1. Referring to FIG. 2, a cross-sectional area of the cooling channel 10 includes the liquid channel area 11 and the gas channel area 12. The liquid channel area 11 is an area in which the first and second fine patterns 210 and 220 are formed. The liquid channel area 11 includes an area in the transverse direction, in which the first fine pattern 210 is formed along the first wall surface 201 of the cooling channel 10, and an area in the longitudinal direction, in which the second fine pattern 220 is formed along the second wall surface 202 of the cooling channel 10. The first and second fine patterns 210 and 220 generate capillary force to fill the liquid channel area 11 with the liquid coolant LC. The liquid channel area 11 forms a passage for the liquid coolant LC. As the second fine pattern 220 is formed on the second wall surface 202, which is a wall surface of the cooling channel 10 in the longitudinal direction, the liquid coolant LC introduced into the package housing 700 through the second opening 702 of the package housing 700 is supplied into the cooling channel 10 along the second wall surface 202 by capillary force generated by the second fine pattern 220, and the liquid coolant LC is moved along the first wall surface 201 by capillary force generated by the first fine pattern 210. The first wall surface 201 is a wall surface of the cooling channel 10 that is close to the semiconductor integrated circuit 120. The first wall surface 201 is a heat transfer surface through which heat from the semiconductor integrated circuit 120 is transferred to the liquid coolant LC of the cooling channel 10. As such, the liquid channel area 11 is formed to include the first wall surface 201 close to the semiconductor integrated circuit 120 from among the walls of the cooling channel 10, and thus, the heat generated in the semiconductor integrated circuit 120 may be effectively transferred to the liquid coolant LC through the first wall surface 201. In addition, the surface area of the first wall surface 201, which is a heat transfer surface, is increased by the first fine pattern 210, and thus, heat exchange efficiency between the semiconductor integrated circuit 120 and the liquid coolant LC may be increased. The heat generated in a heat source (i.e., the semiconductor integrated circuit 120) is transferred to, for example, the liquid coolant LC in the liquid channel area 11. In the liquid channel area 11, the liquid coolant LC is vaporized and phase-changed into the gaseous coolant VC.

The gas channel area 12 is an area in which the first and second fine patterns 210 and 220 are not formed in the inner area of the cooling channel 10. In other words, the gas channel area 12 is the remaining area except for the liquid channel area 11 in the internal area of the cooling channel 10 and communicates with the liquid channel area 11. In some embodiments, the gas channel area 12 includes an area extending in the transverse direction between the third wall surface 203 of the cooling channel 10 and an longitudinal end of the first fine pattern 210 formed on the first wall surface 201, and an area extending in the longitudinal direction between the third wall surface 203 and a transverse end of the second fine pattern 220 formed on the second wall surface 202. The gas channel area 12 forms a passage for the gaseous coolant VC. The gaseous coolant VC generated in the liquid channel area 11 is moved to the gas channel area 12 by capillary force, and an empty space of the liquid channel area 11 from which the gaseous coolant LC escapes is continuously filled with the liquid coolant LC. The gaseous coolant VC is moved to the condenser 800 through the first opening 701 of the package housing 700 along the gas channel area 12. The gaseous coolant VC is phase-changed into a liquid coolant LC in the condenser 800, and then the liquid coolant LC is accommodated in the coolant storage unit 810. The liquid coolant LC is again supplied into the package housing 700 through the second opening 702 provided in the package housing 700, and is moved along the liquid channel area 11 of the cooling channel 10 by capillary force.

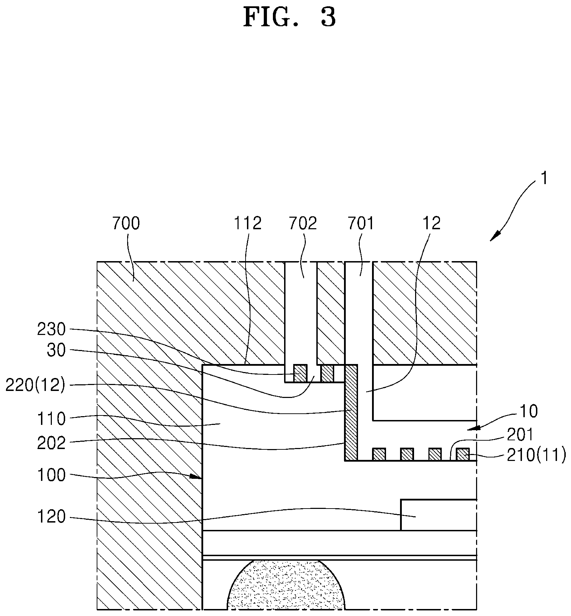

FIG. 3 is a diagram of a semiconductor device 1 according to an embodiment. In FIG. 3, only different parts than the embodiment of the semiconductor device 1 shown in FIG. 1 are shown, and the description of the semiconductor device 1 shown in FIG. 1 applies to the embodiment of the semiconductor device 1 shown in FIG. 3. Therefore, the same components are denoted by the same reference numerals and repeated descriptions thereof may be omitted.

Referring to FIG. 3, a supply channel 30 is provided on the upper surface of the semiconductor chip 100 and connects the second opening 702 to the cooling channel 10. The supply channel 30 is provided between the package housing 700 and the upper surface of the semiconductor chip 100 (for example, the upper surface 112 of the substrate 110). The second opening 702 and the liquid channel area 11 of the cooling channel 10 are connected to each other by the supply channel 30. The supply channel 30 has a third fine pattern 230 that generates capillary force to move the liquid coolant LC. The third fine pattern 230 generates capillary force to move the liquid coolant LC introduced through the second opening 702 to the cooling channel 10. For example, the third fine pattern 230 may be provided on the upper surface of the semiconductor chip 100 (for example, the upper surface 112 of the substrate 110). Accordingly, the liquid coolant LC introduced from the coolant storage unit 810 through the second opening 702 may be moved along the supply channel 30 by the capillary force and effectively supplied to the liquid channel area 11 of the cooling channel 10. The third fine pattern 230 may be the same as or different from the first fine pattern 210. The supply channel 30 may be formed in area, which is connected to at least a portion of the cooling channel 10, in the upper surface of the semiconductor chip 100, that is, the upper surface 112 of the substrate 110. The supply channel 30 may be formed in an area, which surrounds the cooling channel 10, in the upper surface of the semiconductor chip 100, that is, the upper surface 112 of the substrate 110. The supply channel 30 may be formed over the entire upper surface of the semiconductor chip 100, that is, the entire upper surface 112 of the substrate 110.

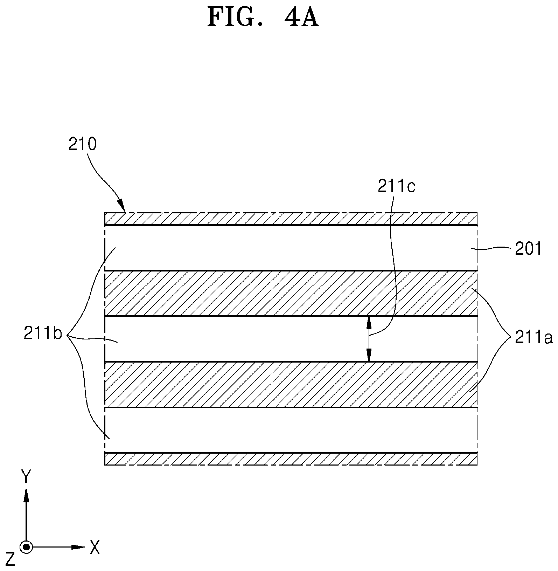

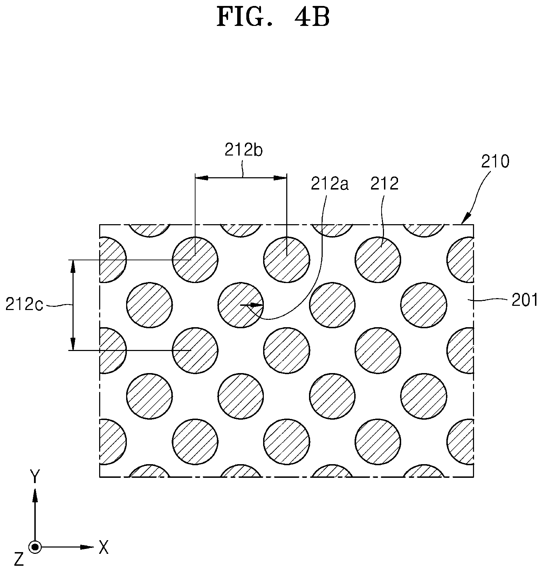

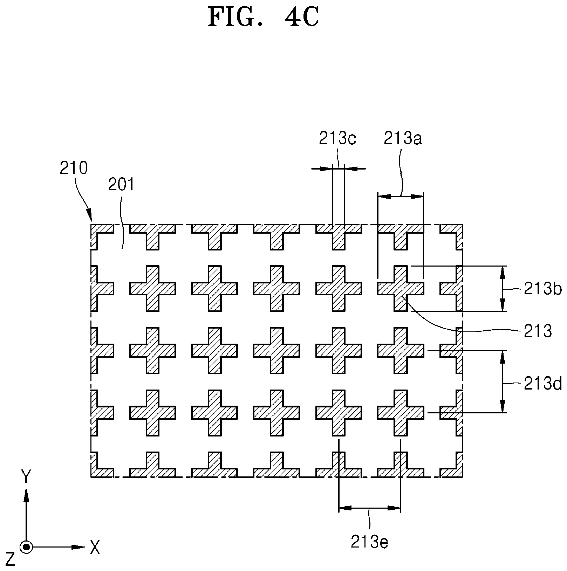

FIGS. 4A, 4B and 4C are diagrams showing various examples of a first fine pattern according to an embodiment. That is, FIGS. 4A to 4C are schematic plan views showing various examples of the first fine pattern 210. Referring to FIG. 4A, the first fine pattern 210 may include a plurality of ridges 211a extending in a transverse direction, for example, in a first direction X. The plurality of ridges 211a may protrude from the first wall surface 201 of the cooling channel 10 in a second direction Z. The plurality of ridges 211a are spaced apart from each other at an interval 211c in a third direction Y to form a wick. A plurality of grooves 211b are formed between the plurality of ridges 211a, and the liquid coolant LC moves along the plurality of grooves 211b by capillarity. The interval 211c (i.e. the width of the groove 211b) and the height of the ridge 211a may be determined to generate capillary force.

For example, the capillary force in a pipe with a wick is defined by Equation (1) below. In Equation (1), $\Delta Pc$ is the capillary force, $\sigma$ is the surface tension, and rc is the capillary radius.

$$\Delta P_c = 2\frac{\sigma}{r_c} \qquad (1)$$

At a capillary limit, the capillary force is equal to a pressure $\Delta P_L$ to move a coolant through the wick. According to Darcy's law, the pressure $\Delta P_L$ may be obtained by Equation (2) below. In Equation (2), $\mu_L$ is the dynamic viscosity of the coolant, $L_{eff}$ is the effective length of the pipe, K is the permeability of the wick, A is the cross-sectional area of the wick, and V is the volume flow rate.

$$\triangle P_L = \frac{\mu_L L_{eff}}{K A_w} V \qquad (2)$$

The volume flow rate V may be obtained by Equation (3) below. In Equation (3), Q is the heat transfer rate, $\rho$ is the density of the coolant, and $\Delta H_{vap}$ is the latent heat of vaporization.

$$V = \frac{Q}{\triangle H_{vap}\rho} \qquad (3)$$

Equation (4) below may be derived from Equations (1), (2), and (3).

$$Q = 2\frac{K A_w \triangle H_{vap}\rho\sigma}{\mu_L L_{eff} r_c} \qquad (4)$$

From Equation (4), an appropriate value of the capillary radius rc may be obtained by considering the amount of heat generated by the integrated circuit die, that is, the semiconductor chip 100.

The height and width 211c of the groove 211b (that is, the length of the groove 211b in the second direction Z and the length of the groove 211b in the third direction Y) may be determined such that the radius of an equivalent circle corresponding to the cross-sectional area of the groove 211b is equal to or less than the value of the capillary radius rc calculated by Equations (1) to (4). For example, the width 211c of the groove 211b may be about 50 $\mu$m, and the width of the ridge 211a may be about 50 $\mu$m. The height of the groove 211b may be appropriately determined by considering the value of the capillary radius rc calculated by Equations (1) to (4).

Referring to FIGS. 4B and 4C, the first fine pattern 210 may include a plurality of fine protrusions 212 and 213 two-dimensionally arranged in the transverse direction (that is, in the first direction X and in the third direction Y). The plurality of fine protrusions 212 and 213 may protrude from the first wall surface 201 of the cooling channel 10 in the second direction Z. The cross-sectional shape of the fine protrusion 212 shown in FIG. 4B in the transverse direction is circular. The liquid coolant LC is moved to a space between two adjacent fine protrusions 212 by capillarity. The height of the fine protrusion 212, a radius 212a of the fine protrusion 212, an interval 212b between the fine protrusions 212 in the first direction X, and an interval 212c between the fine protrusions 212 in the third direction Y may be determined such that that the radius of an equivalent circle corresponding to the cross-sectional area of a space between two adjacent fine protrusions 212 is equal to or less than the value of the capillary radius rc calculated by Equations (1) to (4). For example, the radius 212a of the fine protrusion 212 may be 25 $\mu$m, and the interval 212b between the fine protrusions 212 in the first direction X and the interval 212c between the fine protrusions 212 in the third direction Y may each be 100 $\mu$m. The height of the fine protrusion 212 may be appropriately determined by considering the value of the capillary radius rc calculated by Equations (1) to (4). For example, a width 213a of the fine protrusion 213 in the first direction X and a length 213b of the fine protrusion 213 in the third direction Y may be 40 $\mu$m, and a line width 213c of the fine protrusion 213, an interval 213e between the fine protrusions 213 in the first direction X, and an interval 213d between the fine protrusions 213 in the third direction Y may be 100 $\mu$m. The height of the fine protrusion 213 may be appropriately determined by considering the value of the capillary radius rc calculated by Equations (1) to (4).

The cross-sectional shape of the fine protrusion 213 in the transverse direction shown in FIG. 4C is a cross shape. The liquid coolant LC is moved to a space between two adjacent fine protrusions 213 by capillarity. The height of the fine protrusion 213, the width 213a of the fine protrusion 213 in the first direction X, the length 213b of the fine protrusion 213 in the third direction Y, the line width 213c of the fine protrusion 213, the interval 213e between the fine protrusions 213 in the first direction X, and the interval 213d between the fine protrusions 213 in the third direction Y may be determined so that the radius of an equivalent circle corresponding to the cross-sectional area of a space between two adjacent fine protrusions 213 is equal to or less than the value of the capillary radius rc calculated by Equations (1) to (4).

Various examples of the first fine patterns 210 shown in FIGS. 4A to 4C are exemplary and may have various cross-sectional shapes and arrangements capable of forming capillary force for moving the liquid coolant LC. For example, in FIG. 4A, the cross-sectional shape of each of the ridges 211a in the longitudinal direction may be any shape capable of generating capillary force, such as various polygonal shapes such as triangles and quadrilaterals, partial circular shapes, partial elliptical shapes, and the like. In addition, the cross-sectional shapes of the ridges 211a in the longitudinal direction do not all need to be the same, and a first fine patterns 210 may be implemented by ridges 211a having two or more different cross-sectional shapes in the longitudinal direction. In FIGS. 4B and 4C, the fine protrusions 212 and 213 may have arbitrary polygonal or irregular shapes. In addition, the cross-sectional shapes of the fine protrusions 212 and 213 in the longitudinal direction do not all need to be the same, and a first fine patterns 210 may be implemented by fine protrusions 212 and 213 having two or more different cross-sectional shapes in the longitudinal direction.

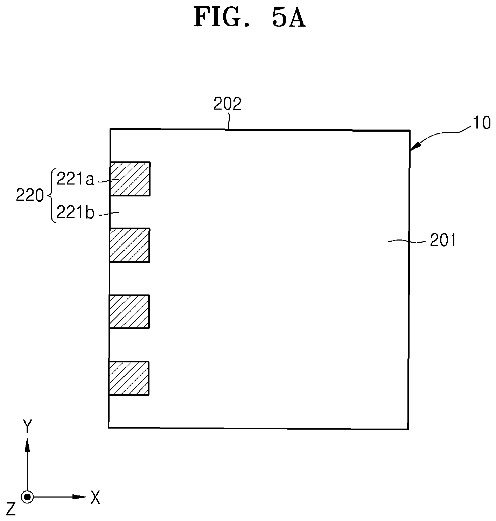

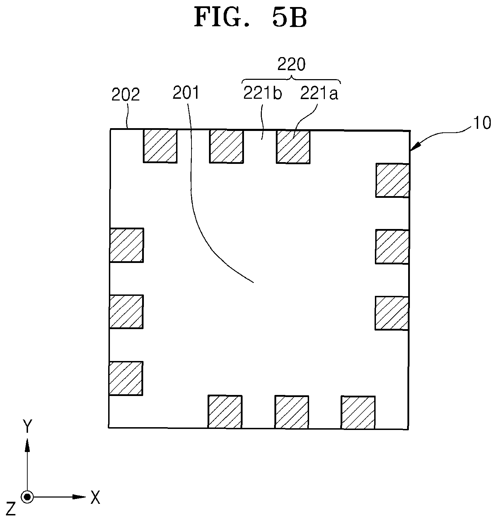

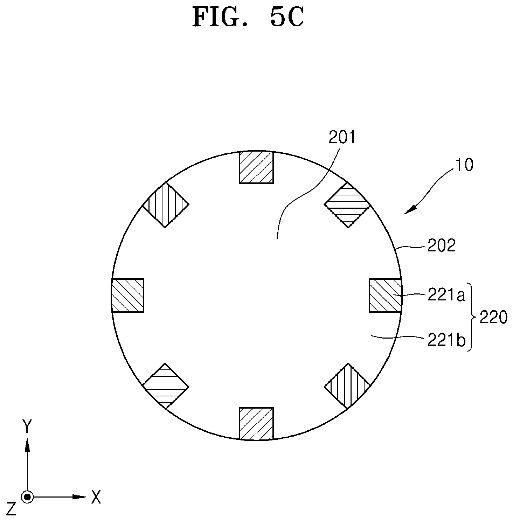

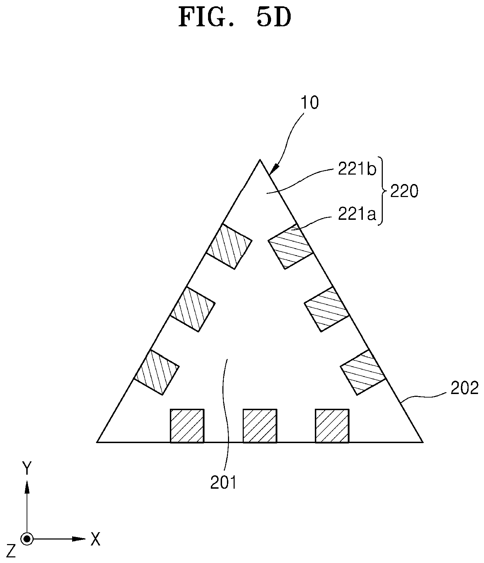

FIGS. 5A, 5B, 5C and 5D are diagrams showing various examples of a cooling channel and a second fine pattern according to an embodiment. That is, FIGS. 5A to 5D are schematic plan views showing various examples of the cooling channel 10 and the second fine pattern 220. For convenience of description, in FIGS. 5A to 5D, the first fine pattern 210 provided on the first wall surface 201 is omitted, and the size of the second fine pattern 220 is exaggerated. Referring to FIGS. 5A and 5B, the cross-sectional shape of the cooling channel 10 in the transverse direction is square. Referring to FIG. 5C, the cross-sectional shape of the cooling channel 10 in the transverse direction is circular. Referring to FIG. 5D, the cross-sectional shape of the cooling channel 10 in the transverse direction is a triangle. The second fine pattern 220 may include a plurality of ridges 221a. In FIG. 5A, the plurality of ridges 221a extend from one wall surface in the transverse direction (for example, a -X direction) from among four second wall surfaces 202 of the cooling channel 10 to the inside of the cooling channel 10, that is, in a +X direction, and are spaced apart from each other at intervals in the third direction Y. In FIG. 5B, the plurality of ridges 221a extend from four second wall surfaces 202 of the cooling channel 10 in the transverse direction to the inside of the cooling channel 10 and are spaced apart from each other at intervals in the first direction X or the third direction Y. In FIG. 5C, the plurality of ridges 221a extend from a circular second wall surface 202 of the cooling channel 10 to the inside of the cooling channel 10 and are spaced apart from each other at intervals in a circumferential direction. In FIG. 5D, the plurality of ridges 221a extend from three second wall surfaces 202 of the cooling channel 10 to the inside of the cooling channel 10 and are spaced apart from each other along the three second wall surfaces 202. In FIGS. 5A to 5D, a plurality of grooves 221b are formed between the plurality of ridges 221a. The liquid coolant LC is moved along the plurality of grooves 221b by capillarity.

The width and length of each of the grooves 221b may be determined to generate capillary force. In other words, the width of the groove 221b and the length of the groove 221b may be determined so that the radius of an equivalent circle corresponding to the cross-sectional area of the groove 221b is equal to or less than the value of the capillary radius rc calculated by Equations (1) to (4).

Various examples of the cooling channel 10 shown in FIGS. 5A to 5D are exemplary. For example, the cross-sectional shape of the cooling channel 10 in the transverse direction is not limited to a triangle, a rectangle, or a circle, but may be various polygons, ellipses, or any irregular shapes. In addition, when a plurality of cooling channels 10 are formed in the semiconductor chip 100, for example, the substrate 110, the cross-sectional shapes of the plurality of cooling channels 10 in the transverse direction do not all need to be the same. In addition to the exemplary cross-sectional shapes shown in FIGS. 5A to 5D, the second fine pattern 220 may have various cross-sectional shapes and arrangements capable of forming capillary force for moving the liquid coolant LC. For example, the cross-sectional shape of each of the ridges 221a in the transverse direction may be any shape capable of generating capillary force, such as various polygonal shapes such as triangles and quadrilaterals, partial circular shapes, partial elliptical shapes, and the like. In addition, the cross-sectional shapes of the ridges 221a in the longitudinal direction do not all need to be the same, and a second fine pattern 220 may be implemented by ridges 221a having two or more different cross-sectional shapes in the longitudinal direction.

As shown in FIG. 3, when the supply channel 30 is provided, the supply channel 30 may be formed to entirely or partially surround the cooling channel 10. The shape of the third fine pattern 230 may be the shape shown in FIGS. 4A to 4C. The third fine pattern 230 is not limited to the examples shown in FIGS. 4A to 4C, and may have various cross-sectional shapes and arrangements capable of forming capillary force for moving the liquid coolant LC along the supply channel 30.

Although only one cooling channel 10 is shown in FIGS. 1 to 3, the number of cooling channels 10 may be two or more. A plurality of cooling channels 10 may be arranged in the transverse direction, for example, in the first direction X and/or in the third direction Y. A plurality of first openings 701 respectively corresponding to the plurality of cooling channels 10 may be provided in the package housing 700. At least one second opening 702 may be provided. A plurality of second openings 702 respectively corresponding to each of the plurality of cooling channels 10 may be provided. A supply channel 30 having a third fine pattern 230 may be provided between the plurality of cooling channels 10 and the second opening 702. The supply channel 30 may be formed to partially or entirely surround the plurality of cooling channels 10, and at least one second opening 702 may be connected to the supply channel 30. The third fine pattern 230 is formed in the supply channel 30.

In FIG. 1 to 3, the cooling channel 10 is provided inside the semiconductor chip 100 (for example, the substrate 110) and is partially opened to the upper surface 112 of the substrate 110. In other words, an upper portion of the cooling channel 10 is covered by the cover 130. The lower surface of the cover 130 forms the third wall surface 203 of the cooling channel 10. However, the structure of the cooling channel 10 is not limited thereto. The cooling channel 10 may be entirely open to the upper surface of the semiconductor chip 100, for example, the upper surface 112 of the substrate 110.

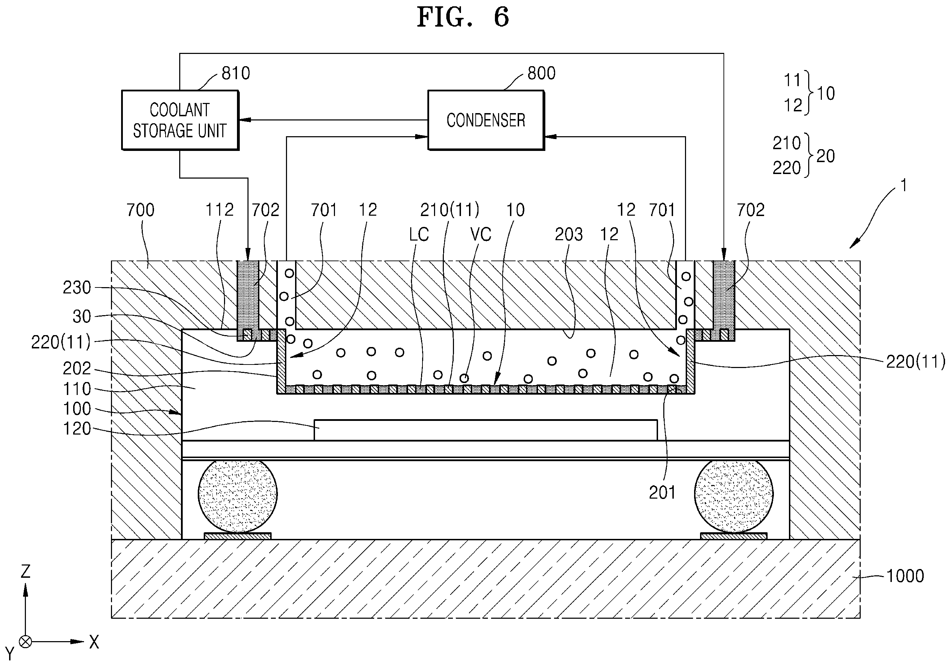

FIG. 6 is a diagram of a semiconductor device 1 according to an embodiment. The embodiment of the semiconductor device 1 shown in FIG. 6 is different from the embodiments of the semiconductor device 1 shown in FIGS. 1 and 3 in that the cooling channel 10 is entirely open to the upper surface of the semiconductor chip 100.

Hereinafter, components having the same functions are denoted by the same reference numerals, and repeated descriptions thereof may be omitted. Referring to FIG. 6, the cooling channel 10 is formed inward (that is, toward the semiconductor integrated circuit 120) from the upper surface of the semiconductor chip 100 (e.g., the upper surface 112 of the substrate 110). The package housing 700 surrounds the semiconductor chip 100. The package housing 700 covers an upper portion of the cooling channel 10. In other words, the package housing 700 forms the third wall surface 203 of the cooling channel 10. A first fine pattern 210 and a second fine pattern 220 are formed on the first wall surface 201 and the second wall surface 202 of the cooling channel 10, respectively. As a result, a cooling channel 10 having a liquid channel area 11 and a gas channel area 12 is formed. The supply channel 30 connects the second opening 702 to the cooling channel 10. A third fine pattern 230 is provided in the supply channel 30.

As described above, a plurality of cooling channels 10 may be provided in the semiconductor chip 100.

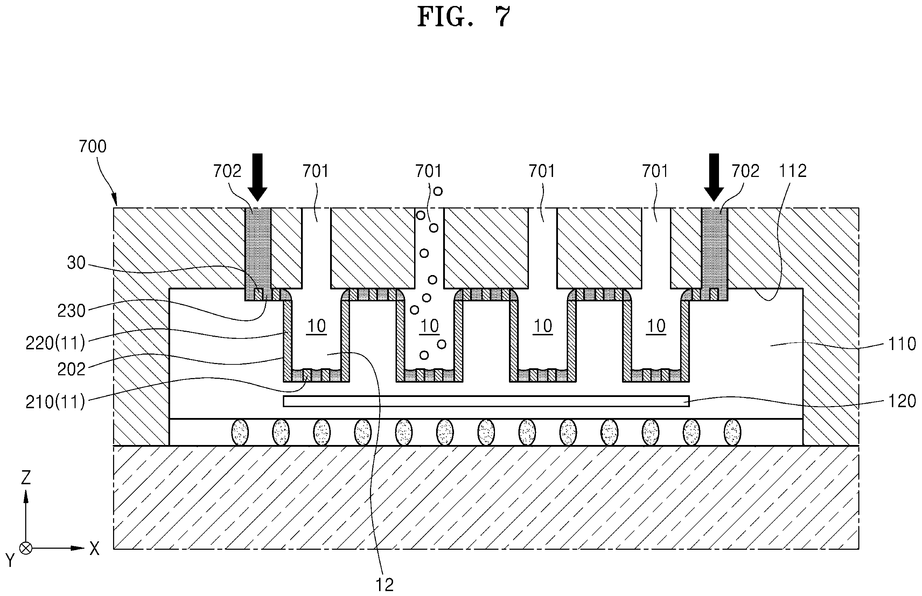

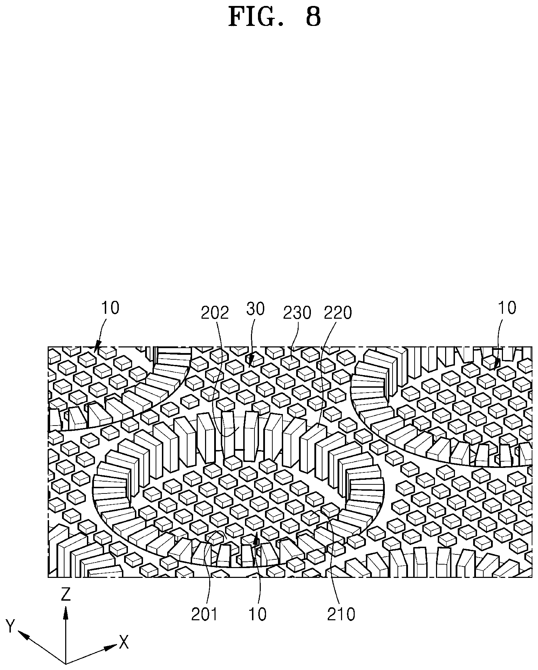

FIG. 7 is a diagram of a semiconductor device 1 according to an embodiment. FIG. 8 is a diagram of a semiconductor chip shown in FIG. 7 according to an embodiment. That is, FIG. 8 is a partial perspective view of a semiconductor chip 100 shown in FIG. 7. The embodiment of the semiconductor device 1 shown in FIGS. 7 and 8 is different from the embodiment of the semiconductor device 1 shown in FIG. 6 in that the semiconductor device 1 shown in FIGS. 7 and 8 includes a plurality of cooling channels 10. Hereinafter, components having the same functions are denoted by the same reference numerals, and repeated descriptions thereof may be omitted. Referring to FIGS. 7 and 8, the plurality of cooling channels 10 are formed inward from the upper surface of the semiconductor chip 100, for example, the upper surface 112 of the substrate 110. In some embodiments, the planar shape of each of the cooling channels 10 is circular, but is not limited thereto. The package housing 700 surrounds the semiconductor chip 100 and covers upper portions of the plurality of cooling channels 10. Each of the cooling channels 10 includes a first fine pattern 210 formed on the first wall surface 201 and a second fine pattern 220 formed on the second wall surface 202. Accordingly, a liquid channel area 11 and a gas channel area 12 are formed in the cooling channel 10. For example, in some embodiments, the diameter of the cooling channel 10 having a circular shape may be about 4.5 mm, and the depth of the cooling channel 10 in the second direction Z may be about 0.4 to 0.6 mm. The second fine patterns 220 may protrude about 0.5 mm inward from the side wall surface of the cooling channel 10 having a circular shape, that is, the second wall surface 202, and may be arranged at intervals of about 5° in a circumferential direction.

A plurality of first openings 701 respectively corresponding to the plurality of cooling channels 10 are provided in the package housing 700. The plurality of first openings 701 are connected to a condenser 800. The package housing 700 is provided with one or more second openings 702 connected to the plurality of cooling channels 10 through a supply channel 30. The second openings 702 are connected to a coolant storage unit 810. A third fine pattern 230 is provided in the supply channel 30. The supply channel 30 connects the plurality of cooling channels 10 to the second openings 702. The supply channel 30 having the third fine pattern 230 may be formed to at least partially surround each of the plurality of cooling channels 10 on the upper surface of the semiconductor chip 100, for example, the upper surface 112 of the substrate 110. In the embodiment, as shown in FIG. 8, the supply channel 30 having the third fine pattern 230 is formed to entirely surround the plurality of cooling channels 10 on the upper surface of the semiconductor chip 100, for example, the upper surface 112 of the substrate 110.

In some embodiments, the third fine pattern 230 is the same as the first fine pattern 210. In other words, the unit patterns of the first fine pattern 210 and the third fine pattern 230 have the same shape and size, and the arrangement intervals of a plurality of unit patterns are the same. In some embodiments, the first fine pattern 210 and the third fine pattern 230 are formed by a two-dimensional array of square unit patterns in a transverse direction. The shapes and sizes of the unit patterns of the first and third fine patterns 210 and 230 and the arrangement intervals of a plurality of unit patterns do not necessarily have to be the same. By making the first fine pattern 210 and the third fine pattern 230 the same, a process of manufacturing the semiconductor chip 100 may be simplified. For example, the upper surface 112 of the substrate 110 of the semiconductor chip 100 may be etched to thereby form a cooling channel 10 in a longitudinal direction (that is, the second direction Z) from the upper surface 112 and a second fine pattern 220 that protrudes from the second wall surface 202 of the cooling channel 10 and extends in the longitudinal direction (that is, the second direction Z). In this state, the first fine pattern 210 and the third fine pattern 230 may be simultaneously formed by etching or laser-ablating the upper surface 112 of the substrate 110 and the first wall surface 201 of the cooling channel 10.

As the semiconductor device 1 is highly integrated and has high performance, a plurality of semiconductor chips 100 may be stacked. The semiconductor device 1 having such a stacked structure is also referred to as a three-dimensional (3D) integrated circuit. In the case of the semiconductor device 1 having a stacked structure, because a plurality of semiconductor chips 100 are closely stacked, an effective two-phase liquid cooling structure is required. The two-phase liquid cooling structure described above may be employed in the semiconductor device 1 having the stacked structure.

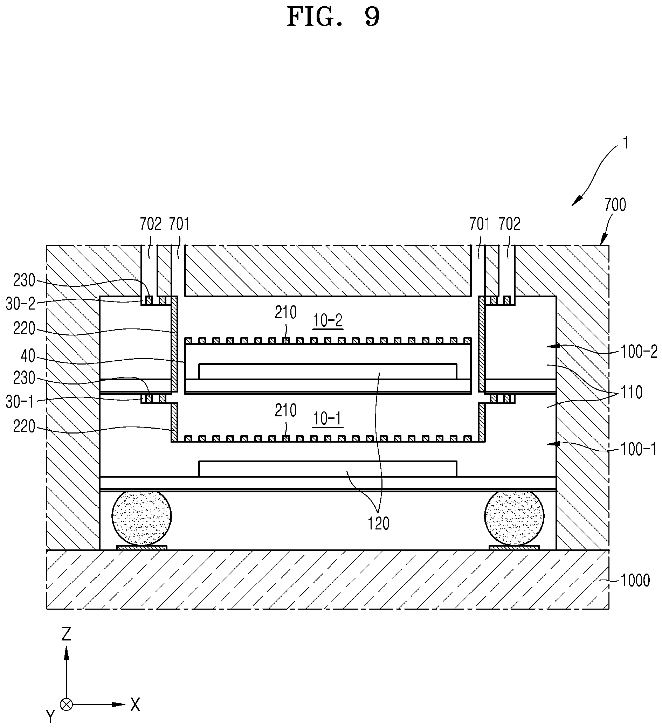

FIG. 9 is a diagram of a semiconductor device 1 according to an embodiment. The semiconductor device 1 according to some embodiments is different from the semiconductor device 1 shown in FIGS. 1 to 8 in that the semiconductor device 1 according to some embodiments includes a plurality of semiconductor chips. Hereinafter, components having the same functions are denoted by the same reference numerals, and repeated descriptions thereof may be omitted.

Referring to FIG. 9, the semiconductor device 1 according to some embodiments may include a plurality of semiconductor chips, for example, first and second semiconductor chips 100-1 and 100-2. A cooling channel 10-1 or 10-2 and a supply channel 30-1 or 30-2 are formed in each of the first and second semiconductor chips 100-1 and 100-2. The descriptions of the cooling channel 10 and the supply channel 30 described above applies to the cooling channels 10-1 and 10-2 and the supply channels 30-1 and 30-2. The structure of the first semiconductor chip 100-1 may be the same as that of the semiconductor chip 100 illustrated in FIGS. 1 to 8 described above. For example, the first semiconductor chip 100-1 according to some embodiments is the same as the semiconductor chip 100 shown in FIG. 6. The second semiconductor chip 100-2 is stacked on the first semiconductor chip 100-1. The second semiconductor chip 100-2 has a form in which a connection channel 40 is formed in the embodiments of the semiconductor chip 100 shown in FIGS. 1 to 8. In some embodiments, the second semiconductor chip 100-2 has a form in which a connection channel 40 is formed in the embodiment of the semiconductor chip 100 shown in FIG. 6. The connection channel 40 may be formed through the second semiconductor chip 100-2. When a plurality of cooling channels 10-2 are provided in the second semiconductor chip 100-2, at least some of the cooling channels 10-2 are connected to the connection channel 40. A fine pattern extending in a longitudinal direction, for example, a second fine pattern 220 may be formed inside the connection channel 40. In the connection channel 40, an area where the second fine pattern 220 is formed is a liquid channel area, and the remaining area is a gas channel area. The connection channel 40 may be connected to the cooling channel 10-1 of the first semiconductor chip 100-1 through the supply channel 30-1 of the first semiconductor chip 100-1, or may be directly connected to the cooling channel 10-1 of the first semiconductor chip 100-1.

The first semiconductor chip 100-1 may be mounted on a printed circuit board 1000 by, for example, solder balls. The second semiconductor chip 100-2 may be directly electrically connected to the printed circuit board 1000 through an electrical connection structure. The second semiconductor chip 100-2 may be electrically connected to the printed circuit board 1000 via the first semiconductor chip 100-1 by using a through-connection structure, such as a through silicon via (TSV).

The first and second semiconductor chips 100-1 and 100-2 are packaged by a package housing 700. The package housing 700 surrounds the first and second semiconductor chips 100-1 and 100-2. A second opening 702 provided in the package housing 700 is connected to a coolant storage unit 810. The second opening 702 is connected to the cooling channel 10-2 via the supply channel 30-2 of the second semiconductor chip 100-2. The connection channel 40 of the second semiconductor chip 100-2 connects the cooling channel 10-2 to the cooling channel 10-1 of the first semiconductor chip 100-1. Accordingly, a liquid coolant LC may be supplied to the cooling channels 10-1 and 10-2 of the first and second semiconductor chips 100-1 and 100-2 through a second opening 702 of the package housing 700. The cooling channel 10-1 of the first semiconductor chip 100-1 is connected to a first opening 701 of the package housing 700 through the connection channel 40 and the cooling channel 10-2 of the second semiconductor chip 100-2. The cooling channel 10-2 of the second semiconductor chip 100-2 is connected to a condenser 800 through the first opening 701. Accordingly, a gaseous coolant VC generated in the cooling channels 10-1 and 10-2 may be discharged to the condenser 800 through the first opening 701. In FIG. 9, the second semiconductor chip 100-2 is stacked on the first semiconductor chip 100-1 without a gap, but the second semiconductor chip 100-2 may be stacked on the first semiconductor chip 100-1 at intervals.

The liquid coolant LC is supplied to the cooling channels 10-1 and 10-2 provided inside the stacked first and second semiconductor chips 100-1 and 100-2. The liquid coolant LC moves along the liquid channel area 11, and absorbs heat from a heat source of the first and second semiconductor chips 100-1 and 100-2, for example, the semiconductor integrated circuit 120 and vaporizes to be a gaseous coolant VC. The gaseous coolant VC moves from the liquid channel area 11 to the gas channel area 12. The liquid coolant LC fills, by capillary force, a space where the gaseous coolant VC escapes from the liquid channel area 11. The gaseous coolant VC is moved to the condenser 800 along the gas channel area 12. The gaseous coolant VC is phase-changed into a liquid coolant LC in the condenser 800, and then the liquid coolant LC passes through the coolant storage unit 810 and is again moved into the first and second semiconductor chips 100-1 and 100-2 along the liquid channel areas of the cooling channels 10-1 and 10-2 by capillary force. With this configuration, the liquid coolant LC may be supplied to a location close to the heat source inside the stacked first and second semiconductor chips 100-1 and 100-2. In addition, the gaseous coolant VC may be effectively discharged to the outside of the first and second semiconductor chips 100-1 and 100-2 along the gas channel area 12. Therefore, the first and second semiconductor chips 100-1 and 100-2 may be effectively cooled.

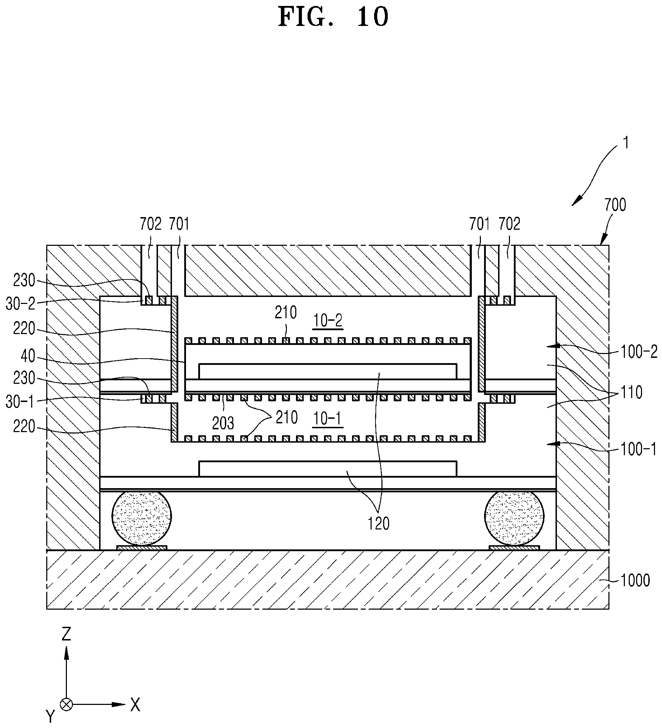

FIG. 10 is a diagram of a semiconductor device 1 according to an embodiment. The semiconductor device 1 according to some embodiments is different from the semiconductor device 1 shown in FIG. 9 in that the first fine pattern 210 is formed on the lower surface of the second semiconductor chip 100-1, that is, on the third wall surface 203 of the cooling channel 10-2 of the first semiconductor chip 100-1. The first fine pattern 210 may be formed in a region of the third wall surface 203 corresponding to at least an upper portion of the cooling channel 10-1. According to this configuration, when the semiconductor device 1 is placed upright, the liquid channel area 11 is also formed near the third wall surface 203, and thus, the second semiconductor chip 100-2 may be effectively cooled.

The number of integrated circuit dies that are stacked may be three or more.

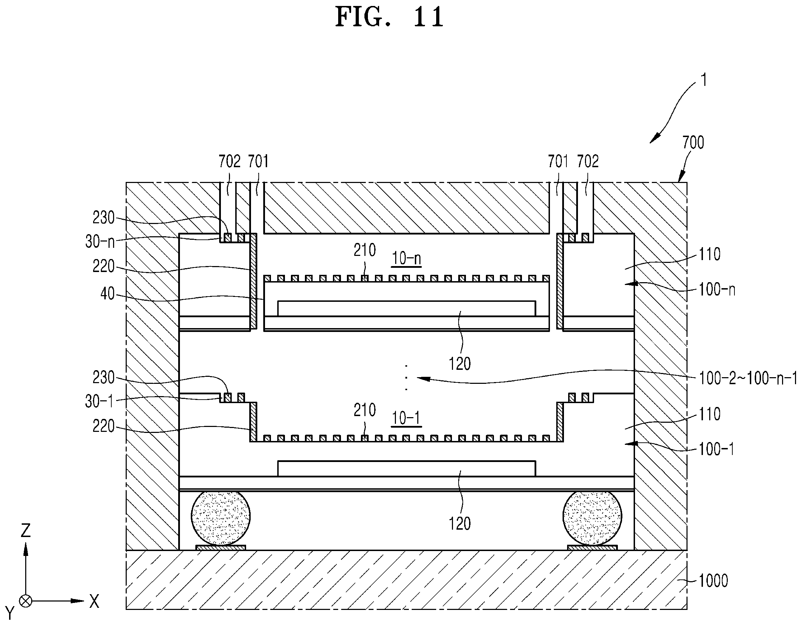

FIG. 11 is a diagram of a semiconductor chip 1 according to an embodiment. The integrated circuit device 1 according to some embodiments is different from the semiconductor device 1 shown in FIGS. 9 and 10 in that the integrated circuit device 1 according to some embodiments includes n semiconductor chips (where n is an integer that is greater than or equal to 1). Descriptions of the embodiments of the semiconductor device 1 shown in FIGS. 1 to 10 equally apply to the embodiment of the semiconductor device 1 shown in FIG. 11 unless contradictory. Hereinafter, components having the same functions are denoted by the same reference numerals, and repeated descriptions thereof may be omitted.

Referring to FIG. 11, a plurality of semiconductor chips 100-1 to 100-n are stacked in the longitudinal direction (that is, in the second direction Z). The structure of the lowermost semiconductor chip (that is, a first semiconductor chip 100-1) is the same as that of the first semiconductor chip 100-1 shown in FIG. 9. The structure of the uppermost semiconductor chip 100-n is the same as that of the second semiconductor chip 100-2 shown in FIG. 9 or 10. One or more intermediate semiconductor chips 100-2 to 100-n-1 are located between the first semiconductor chip 100-1 and the uppermost semiconductor chip 100-n. The structures of the intermediate semiconductor chips 100-2 to 100-n-1 are the same as that of the uppermost semiconductor chip 100-n. In other words, a connection channel 40 penetrating in the longitudinal direction is provided in the remaining semiconductor chips 100-2 to 100-n, except for the lowermost semiconductor chip (that is, the first semiconductor chip 100-1) from among the plurality of semiconductor chips 100-1 to 100-n. A second fine pattern 220 extending in the longitudinal direction is provided on at least a portion of the wall surface of the connection channel 40. The first semiconductor chip 100-1 may be mounted on a printed circuit board 1000 by, for example, solder balls. The intermediate semiconductor chips 100-2 to 100-n-1 and the uppermost semiconductor chip 100-n may be directly electrically connected to the printed circuit board 1000 by an electrical connection structure. The intermediate semiconductor chips 100-2 to 100-n-1 and the uppermost semiconductor chip 100-n may be electrically connected to the printed circuit board 1000 via the first semiconductor chip 100-1 by using a through-connection structure, such as a TSV.

The first to n-th semiconductor chips (that is, the plurality of semiconductor chips 100-1 to 100-n) are packaged by a package housing 700. The package housing 700 surrounds the first to n-th semiconductor chips (that is, the plurality of semiconductor chips 100-1 to 100-n). The package housing 700 is provided with a second opening 702 communicating with a cooling channel 10-n through a supply channel 30-n of the uppermost semiconductor chip 100-n. The second opening 702 is connected to a coolant storage unit 810. The second opening 702 is connected to cooling channels 10-2 to 10-n-1 of the intermediate semiconductor chips 100-2 to 100-n-1 and a cooling channel 10-1 of the first semiconductor chip 100-1 through the connection channel 40 provided in the uppermost semiconductor chip 100-n and the intermediate semiconductor chips 100-2 to 100-n-1. Accordingly, the liquid coolant LC may be supplied to the cooling channels 10-1 to 10-n of the plurality of semiconductor chips 100-1 to 100-n through the second opening 702 of the package housing 700. The cooling channel 10-n of the uppermost semiconductor chip 100-n is connected to a condenser 800 through a first opening 701. As a result, the gaseous coolant VC generated in the cooling channels 10-1 to 10-n may be discharged to the condenser 800 through the first opening 701. The plurality of semiconductor chips 100-1 to 100-n may be stacked without intervals or may be stacked with intervals.

The liquid coolant LC is supplied to the cooling channels 10-1 to 10-n provided inside the plurality of semiconductor chips 100-1 to 100-n that are stacked. The liquid coolant LC moves along the liquid channel area 11, and absorbs heat from a heat source of the plurality of semiconductor chips 100-1 to 100-n (for example, the semiconductor integrated circuit 120) and vaporizes to be a gaseous coolant VC. The gaseous coolant VC moves from the liquid channel area 11 to the gas channel area 12. The liquid coolant LC fills, by capillary force, a space where the gaseous coolant VC escapes from the liquid channel area 11. The gaseous coolant VC is moved to the condenser 800 along the gas channel area 12. The gaseous coolant VC is phase-changed into a liquid coolant LC in the condenser 800, and then the liquid coolant LC passes through the coolant storage unit 810 and is again moved into the plurality of semiconductor chips 100-1 to 100-n along the liquid channel area 11 of the cooling channels 10-1 to 10-n by capillary force. With this configuration, the liquid coolant LC may be supplied to a location close to the heat source inside the plurality of semiconductor chips 100-1 to 100-2 that are stacked. In addition, the gaseous coolant VC may be effectively discharged to the outside of the plurality of semiconductor chips 100-1 to 100-n along the gas channel area 12. Therefore, the plurality of semiconductor chips 100-1 to 100-n may be effectively cooled.

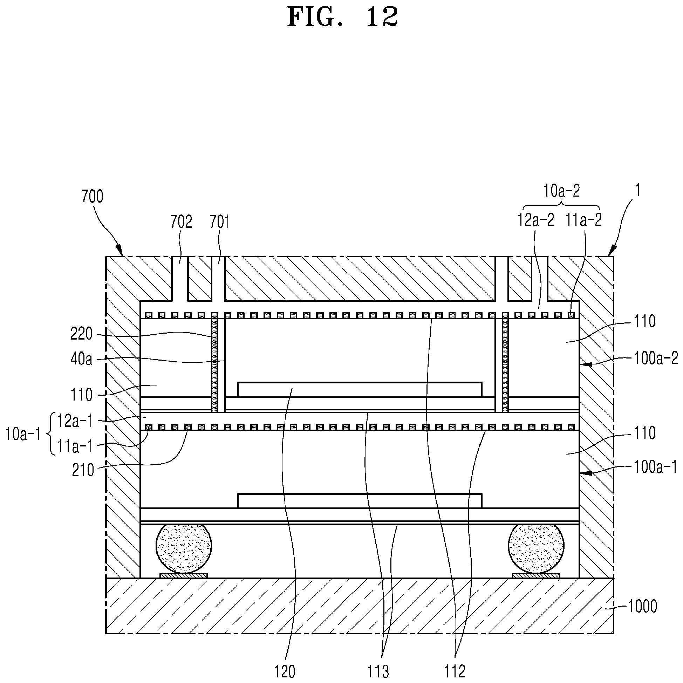

FIG. 12 is a diagram of a semiconductor device 1 according to an embodiment. The semiconductor device 1 according to some embodiments is different from the above-described embodiments in that a cooling channel is formed on the upper surface of a semiconductor chip. Hereinafter, components having the same functions are denoted by the same reference numerals, repeated descriptions thereof may be omitted, and differences are mainly described.

Referring to FIG. 12, the semiconductor device 1 according to some embodiments may include a plurality of semiconductor chips (for example, first and second semiconductor chips 100a-1 and 100a-2). The second semiconductor chip 100a-2 is stacked on the first semiconductor chip 100a-1 in the longitudinal direction (that is, in the second direction Z). Each of the first and second semiconductor chips 100a-1 and 100a-2 may include a substrate 110 and a semiconductor integrated circuit 120 formed on one surface of the substrate 110. The descriptions of the substrate 110 and the semiconductor integrated circuit 120 of the semiconductor chip 100 shown in FIG. 1 may apply to the substrate 110 and the semiconductor integrated circuit 120 of each of the first and second semiconductor chips 100a-1 and 100a-2.

A cooling channel (e.g., an external cooling channel) 10a-1 is formed between the first and second semiconductor chips 100a-1 and 100a-2 adjacent to each other. The second semiconductor chip 100a-2 may be stacked to be apart from an upper surface 112 of the first semiconductor chip 100a-1 and the cooling channel 10a-1 may be formed between a lower surface 113 of the second semiconductor chip 100a-2 and an upper surface 112 of the first semiconductor chip 100a-1. A first fine pattern 210 may be formed on at least a portion of a wall surface of the cooling channel 10a-1 in a transverse direction. The first fine pattern 210 generates capillary force to move the liquid coolant LC in the transverse direction. For example, the first fine pattern 210 may be formed on an upper surface of a lower semiconductor chip of two adjacent semiconductor chips (that is, an upper surface of the first semiconductor chip 100a-1, the upper surface 112 of the substrate 110, etc.). The upper surface of the first semiconductor chip 100a-1 corresponds to the first wall surface 201 in the embodiments described above. In the cooling channel 10a-1, an area where the first fine pattern 210 is formed is a liquid channel area 11a-1, and the remaining area is a gas channel area 12a-1.

A cooling channel (e.g., an external cooling channel) 10a-2 is formed on the upper surface 112 of the second semiconductor chip 100a-2. For example, the first and second semiconductor chips 100a-1 and 100a-2 are packaged by a package housing 700. The package housing 700 is apart from the upper surface 112 of the second semiconductor chip 100a-2, and a cooling channel 10a-2 is formed between the upper surface 112 of the second semiconductor chip 100a-2 and the package housing 700. The first fine pattern 210 is formed on at least a portion of the wall surface of the cooling channel 10a-2, for example, on the upper surface (i.e., the upper surface 112 of the substrate 112) of the second semiconductor chip 100a-2 corresponding to the first wall surface in the embodiments described above. In the cooling channel 10a-2, an area where the first fine pattern 210 is formed is a liquid channel area 11a-2, and the remaining area is a gas channel area 12a-2.

The second semiconductor chip 100a-2 is provided with a connection channel 40a communicating the cooling channel 10a-2 with the cooling channel 10a-1 of the first semiconductor chip 100a-1. The connection channel 40a may be formed by passing through the second semiconductor chip 100a-2 in the longitudinal direction, that is, in the second direction Z. A second fine pattern 220 is provided on at least a portion of the wall surface of the connection channel 40a.

The first semiconductor chip 100a-1 may be mounted on a printed circuit board 1000 by, for example, solder balls. The second semiconductor chip 100a-2 may be directly electrically connected to the printed circuit board 1000 by an electrical connection structure. For example, the second semiconductor chip 100a-2 may be electrically connected to the printed circuit board 1000 via the first semiconductor chip 100a-1 by using a through-connection structure, such as a TSV.

The package housing 700 is provided with first and second openings 701 and 702 communicating with the cooling channel 10a-2 of the second semiconductor chip 100a-2. The first and second openings 701 and 702 are connected to a condenser 800 and a coolant storage unit 810, respectively. The liquid coolant LC may move to the cooling channel 10a-2 of the second semiconductor chip 100a-2 through the second opening 702, and may move to the cooling channel 10a-1 of the first semiconductor chip 100a-1 through the connection channel 40a. Accordingly, the liquid coolant LC may be supplied to the cooling channels 10a-1 and 10a-2 through the second opening 702.

The liquid coolant LC absorbs heat from a heat source of the first and second semiconductor chips 100a-1 and 100a-2 (for example, a semiconductor integrated circuit 120) and vaporizes to be the gaseous coolant VC. The gaseous coolant VC is moved from the liquid channel areas 11a-1 and 11a-2 to the gas channel areas 12a-1 and 12a-2. The liquid coolant LC fills, by capillary force, in spaces where the gaseous coolant VC escapes from the liquid channel areas 11a-1 and 11a-2. The gaseous coolant VC moves along the gas channel areas 12a-1 and 12a-2 and moves to the condenser 800 through the first opening 701. The gaseous coolant VC is phase-changed into a liquid coolant LC in the condenser 800, and then the liquid coolant LC passes through the coolant storage unit 810 and is again supplied to the liquid channel areas 11a-1 and 11a-2 of the cooling channels 10a-1 and 10a-2 by capillary force. With this configuration, the stacked first and second semiconductor chips 100a-1 and 100a-2 may be effectively cooled.

A first fine pattern 210 may be formed on the lower surface 113 of the second semiconductor chip 100a-2. The lower surface 113 of the second semiconductor chip 100a-1 corresponds to a third wall surface of the cooling channel 10a-2. This structure may be clearly understood by referring to FIG. 10. According to this configuration, when the semiconductor device 1 is placed upright, a liquid channel area is also formed near the lower surface 113 of the second semiconductor chip 100a-2, and thus, the second semiconductor chip 100a-2 may be effectively cooled.

The number of semiconductor chips that are stacked may be three or more.

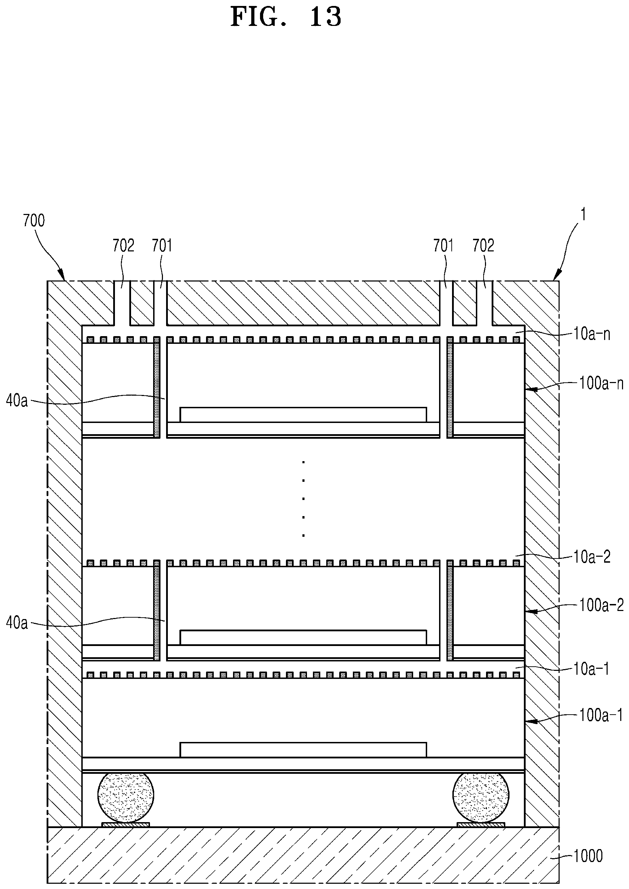

FIG. 13 is a diagram of a semiconductor device 1 according to an embodiment. The semiconductor device 1 according to some embodiments is different from the integrated circuit device 1 shown in FIG. 12 in that the semiconductor device 1 according to some embodiments includes n semiconductor chips (where n is an integer that is greater than or equal to 1). The description of the integrated circuit device 1 shown in FIG. 12 equally applies to the integrated circuit device 1 shown in FIG. 13 unless contradictory. Hereinafter, components having the same functions are denoted by the same reference numerals, and repeated descriptions thereof may be omitted.

Referring to FIG. 13, a plurality of semiconductor chips (that is, first to n-th semiconductor chips 100a-1 to 100a-n) are stacked in the longitudinal direction (that is, in the second direction Z). The structure of the first semiconductor chip 100a-1 is the same as that of the first semiconductor chip 100a-1 of FIG. 12. The second to n-th semiconductor chips 100a-2 to 100a-n are sequentially stacked on the first semiconductor chip 100a-1. The structures of the second to n-th semiconductor chips 100a-2 to 100a-n are the same as that of the second integrated circuit die 100a-2 of FIG. 12. The first semiconductor chip 100a-1 may be mounted on a printed circuit board 1000 by, for example, solder balls. The second to n-th semiconductor chips 100a-2 to 100a-n may be directly electrically connected to the printed circuit board 1000 by an electrical connection structure. For example, the second to n-th semiconductor chips 100a-2 to 100a-n may be electrically connected to the printed circuit board 1000 via the first semiconductor chip 100a-1 by using a through-connection structure, such as a TSV.

A plurality of cooling channels (external cooling channels) 10a-1 to 10a-n are formed between the first to n-th semiconductor chips 100a-1 to 100a-n-1. Another cooling channel (external cooling channel) 10a-n may be formed between a package housing 700 and the uppermost semiconductor chip (that is, the n-th semiconductor chip 100a-n). The plurality of cooling channels 10a-1 to 10a-n communicate with each other by a plurality of connection channels 40a passing through the second to n-th semiconductor chips 100a-2 to 100a-n. The first to n-th semiconductor chips 100a-1 to 100a-n are packaged by the package housing 700. The package housing 700 is provided with a first opening 701 and a second opening 702, which communicate with the cooling channel 10a-n of the uppermost semiconductor chip (that is, the n-th semiconductor chip 100a-n). The first opening 701 is connected to a condenser 800. The second opening 702 is connected to a coolant storage unit 810. The liquid coolant LC is moved to liquid channel areas 11a-1 to 11a-n of the plurality of cooling channels 10a-1 to 10a-n of the first to n-th semiconductor chips 100a-1 to 100a-n1 through the second opening 702. The liquid coolant LC absorbs heat from a heat source of the first to n-th semiconductor chips 100a-1 to 100a-n1 (for example, a semiconductor integrated circuit 120) and vaporizes to be the gaseous coolant VC. The gaseous coolant VC is moved from the liquid channel areas 11a-1 to 11a-n to gas channel areas 12a-1 to 12a-n. The liquid coolant LC fills, by capillary force, in spaces where the gaseous coolant VC escapes from the liquid channel areas 11a-1 to 11a-n. The gaseous coolant VC moves along the gas channel areas 12a-1 to 12a-n and is discharged to the condenser 800 through the first opening 701. The gaseous coolant VC is phase-changed into a liquid coolant LC in the condenser 800, and then the liquid coolant LC passes through the coolant storage unit 810 and is again moved along the liquid channel areas 11a-1 to 11a-n of the cooling channels 10a-1 to 10a-2 by capillary force. With this configuration, the stacked first to n-th semiconductor chips 100a-1 to 100a-n may be effectively cooled.

A first fine pattern 210 may be formed on lower surfaces 113 of the second to n-th semiconductor chips 100a-2 to 100a-n. The lower surfaces 113 of the second to n-th semiconductor chips 100a-2 to 100a-n correspond to third wall surfaces of the cooling channels 10a-1 to 10a-n-1. This structure may be clearly understood by referring to FIG. 10. According to this configuration, when the semiconductor device 1 is placed upright, a liquid channel area is also formed near the lower surfaces 113 of the second to n-th semiconductor chips 100a-2 to 100a-n, and thus, the second to n-th semiconductor chips 100a-2 to 100a-n may be effectively cooled.

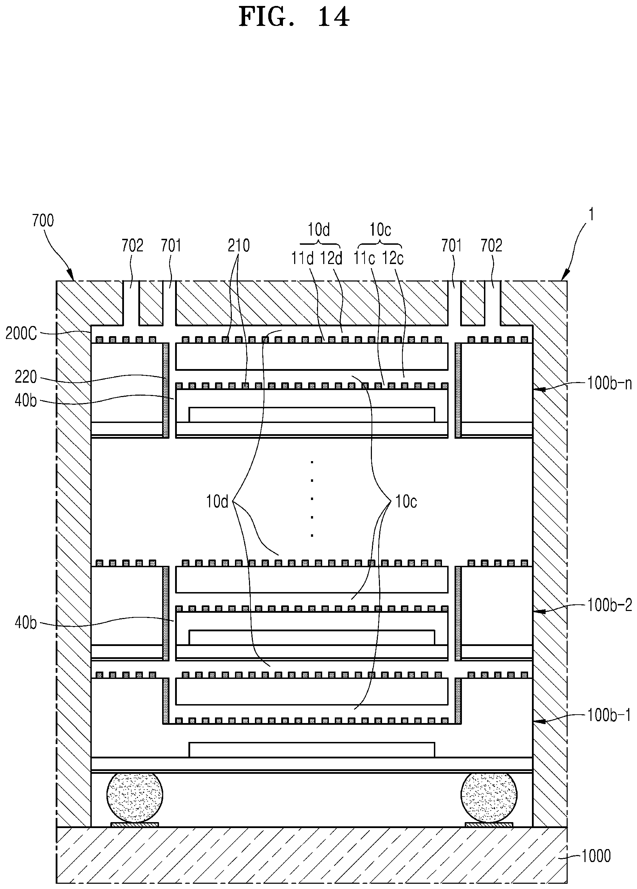

FIG. 14 is a diagram of a semiconductor device 1 according to an embodiment. The semiconductor device 1 according to some embodiments is different from the semiconductor device 1 shown in FIG. 13 in that a cooling channels are formed inside a semiconductor chip and on the upper surface of a semiconductor chip (that is, between two adjacently stacked semiconductor chips). In other words, the semiconductor device 1 according to some embodiments is a combination of the embodiment of the semiconductor device 1 shown in FIG. 1 and the embodiment of the semiconductor device 1 shown in FIG. 13. Accordingly, descriptions of the embodiments of the semiconductor device 1 shown in FIGS. 1 and 13 equally apply to the embodiment of the semiconductor device 1 shown in FIG. 14 unless contradictory. Hereinafter, components having the same functions are denoted by the same reference numerals, and repeated descriptions thereof may be omitted.

Referring to FIG. 14, a plurality of semiconductor chips 100b-1 to 100b-n are stacked in the longitudinal direction (that is, in the second direction Z). Inner cooling channels 10c are formed in a transverse direction inside each of the plurality of semiconductor chips 100b-1 to 100b-n. The inner cooling channels 10c are the same as the cooling channel 10 described with reference to FIGS. 1 to 5. Therefore, a cross-sectional area of each of the inner cooling channels 10c includes a liquid channel area 11c in which first and second fine patterns 210 and 220 are formed and the liquid coolant LC flows, and a gas channel area 12c in which the first and second fine patterns 210 and 220 are not formed to form a passage for the gaseous coolant VC.

A plurality of outer cooling channels 10d are formed in the transverse direction on the upper surface of each of the plurality of semiconductor chips 100b-1 to 100b-n. The outer cooling channels 10d are the same as the cooling channel 10a described with reference to FIGS. 12 and 13. An outer cooling channel 10d of the uppermost semiconductor chip 100b-n may be formed between a package housing 700 and the uppermost semiconductor chip 100b-n. Therefore, a cross-sectional area of each of the outer cooling channels 10d includes a liquid channel area 11d in which a first fine pattern(fourth fine pattern) 210 is formed and the liquid coolant LC flows, and a gas channel area 12d in which the first fine pattern(fourth fine pattern) 210 is not formed to form a passage for the gaseous coolant VC.

A plurality of connection channels 40b are formed by passing through the second to n-th semiconductor chips 100b-2 to 100b-n in the longitudinal direction and connect the plurality of inner cooling channels 10c to the plurality of outer cooling channels 10d. The plurality of connection channels 40b are the same as the connection channel 40a described with reference to FIGS. 13 and 14. A second fine pattern 220 may be formed in the plurality of connection channels 40b.

The first semiconductor chip 100b-1 may be mounted on a printed circuit board 1000 by, for example, solder balls. The second to n-th semiconductor chips 100b-2 to 100b-n may be directly electrically connected to the printed circuit board 1000 by an electrical connection structure. For example, the second to n-th semiconductor chips 100b-2 to 100b-n may be electrically connected to the printed circuit board 1000 via the first semiconductor chip 100b-1 by using a through-connection structure, such as a TSV.

The first to n-th semiconductor chips 100b-1 to 100b-n are packaged by the package housing 700. The package housing 700 is provided with first and second openings 701 and 702. The first opening 701 and the second opening 702 are connected to a condenser 800 and a coolant storage unit 810, respectively. The second fine pattern 220 may also be provided on at least a portion of the wall surface of the first opening 701. The liquid coolant LC is supplied, through the second opening 702, to the inner cooling channels 10c and the outer cooling channels 10d of the first to n-th semiconductor chips 100b-1 to 100b-n, and is moved along the liquid channel areas 11c and 11d. The liquid coolant LC absorbs heat from a heat source of the first to n-th semiconductor chips 100b-1 to 100b-n (for example, a semiconductor integrated circuit 120) and vaporizes to be the gaseous coolant VC. The gaseous coolant VC is moved from the liquid channel areas 11c and 11d to the gas channel areas 12c and 12d. The liquid coolant LC fills, by capillary force, in spaces where the gaseous coolant VC escapes from the liquid channel areas 11c and 11d. The gaseous coolant VC moves along the gas channel areas 12c and 12d and is discharged to the condenser 800 through the first opening 701. The gaseous coolant VC is phase-changed to a liquid coolant LC in the condenser 800, and then the liquid coolant LC passes through the coolant storage unit 810 and is again supplied to the plurality of inner and outer cooling channels 10c and 10d by capillary force. According to this configuration, the stacked first to n-th semiconductor chips 100b-1 to 100b-n may be effectively cooled because heat exchange occurs between the upper surfaces and the insides of the stacked first to n-th semiconductor chips 100b-1 to 100b-n.

A first fine pattern 210 may be formed on lower surfaces 113 of the second to n-th semiconductor chips 100b-2 to 100b-n. The lower surfaces 113 of the second to n-th semiconductor chips 100b-2 to 100b-n correspond to third wall surfaces of a plurality of outer cooling channels 10d-1 to 10d-n-1. This structure may be clearly understood by referring to FIG. 10. According to this configuration, when the semiconductor device 1 is placed upright, a liquid channel area is also formed near the lower surfaces 113 of the second to n-th semiconductor chips 100b-2 to 100b-n, and thus, the second to n-th semiconductor chips 100b-2 to 100b-n may be effectively cooled.

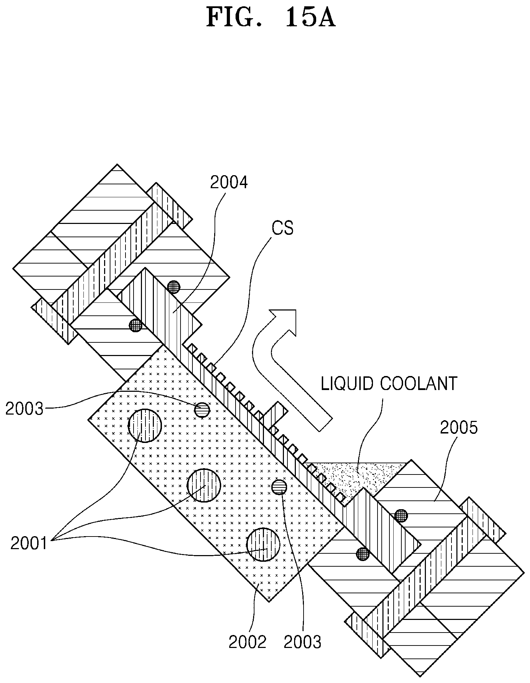

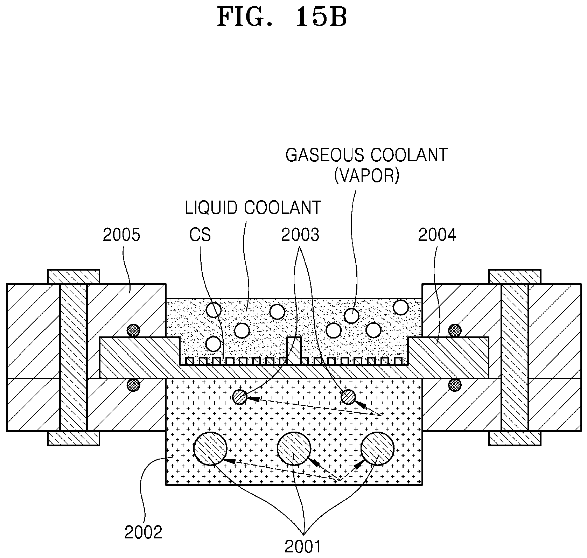

FIGS. 15A and 15B are diagrams an example of an apparatus for verifying the effect of a semiconductor device 1 according to an embodiment. Referring to FIGS. 15A and 15B, a plate material 2004 having a surface on which a capillary structure CS is formed is placed to contact an upper surface of a heat block 2002 having a heat source 2001. A temperature sensor 2003 is disposed between the heat source 2001 and the plate material 2004. The device of this type is tilted as shown in FIG. 15A such that a liquid coolant (water) is moved along the surface of the plate material 2004 by capillary force generated by the capillary structure CS. In this state, the heat source 2001 is driven and the temperature of the heat block 2002 is detected using the temperature sensor 2003 (a first example). The device is placed horizontally as shown in FIG. 15B, the liquid coolant (water) is filled in a container 2006 formed by the plate material 2004 and a jig 2005, the heat source 2001 is driven, and the temperature of the heat block 2002 is detected using the temperature sensor 2003 (a second example). FIG. 15A may correspond to the semiconductor device 1 according to an embodiment, and FIG. 15B may correspond to an immersion cooling method.

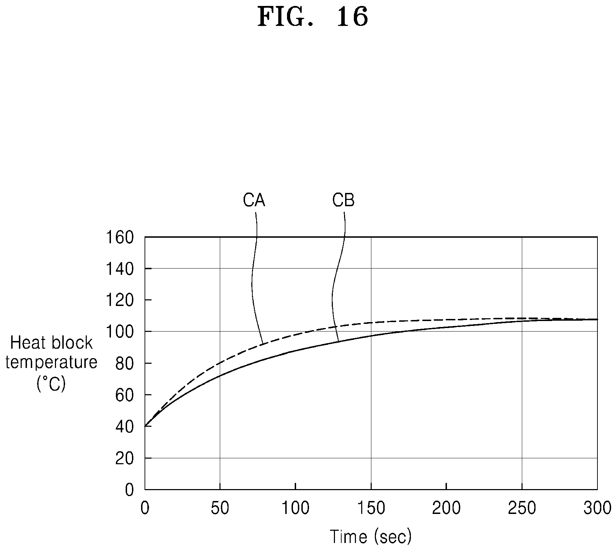

FIG. 16 is a graph showing the results of experiments performed by using the devices of FIGS. 15A and 15B. In FIG. 16, a curve CA represents the result of the first example shown in FIG. 15A, and a curve CB represents the result of the second example shown in FIG. 15B. As shown in FIGS. 15A and 15B, it may be understood that, although a temperature rise time is different between the first example (FIG. 15A) and the second example (FIG. 15B), the saturation temperature of the heat block 2002 is the same in the first example (FIG. 15A) and the second example (FIG. 15B). As such, in the semiconductor device 1 according to the disclosure, almost the same cooling performance as that of the immersion cooling method may be obtained.

Another semiconductor chip not employing a cooling structure may be arranged on the printed circuit board 1000. The other semiconductor chip not employing a cooling structure may be packaged by a separate housing, and may be packaged in one housing together with a semiconductor chip employing a cooling structure. In this case, the other semiconductor chip not employing a cooling structure may be sealed so as not to contact a cooling fluid. This structure may also be applied to the embodiments of the semiconductor device 1 shown in FIGS. 1 to 14. A plurality of semiconductor chips may be arranged in a transverse direction. For example, in the embodiment of the semiconductor device 1 shown in FIG. 1, two or more semiconductor chips 100 may be arranged in a transverse direction.

According to the above-described embodiments of the semiconductor device according to the disclosure, a semiconductor device employing a two-phase liquid cooling structure capable of coping with a decrease in cooling efficiency due to adsorption of vapor may be implemented by securing a passage for a gaseous coolant.

**Claims**

1. A semiconductor device (1) comprising:

   a semiconductor chip (100) comprising a semiconductor integrated circuit (120); and
   a cooling channel (10) comprising:

   at least a first portion that is inside the semiconductor chip;
   a wall surface comprising a fine pattern configured to generate a capillary force that causes a liquid coolant to flow in the cooling channel;
   a liquid channel area (11) in a first area of the cooling channel where the fine pattern (20) is formed and configured to pass the liquid coolant; and
   a gas channel area (12) in a second area of the cooling channel where the fine pattern is not formed and configured to pass a gaseous coolant;
   **characterized in that** the wall surface comprises a first wall surface (201) extending in a transverse direction in the cooling channel and a second wall surface (202) extending in a longitudinal direction from the first wall surface, and
   wherein the fine pattern comprises:

   a first fine pattern (210) formed on the first wall surface, and
   a second fine pattern (220) formed on the second wall surface.

2. The semiconductor device of claim 1, wherein an entirety of the cooling channel is formed inside the semiconductor chip.

3. The semiconductor device of claim 1 or 2, wherein the at least first portion of cooling channel is formed inward from an upper surface of the semiconductor chip.

4. The semiconductor device of claim 1, wherein the first fine pattern is configured to generate a capillary force that moves the liquid coolant in the transverse direction along the first wall surface, and
   wherein the second fine pattern is configured to generate a capillary force that moves the liquid coolant in the longitudinal direction along the second wall surface and to the first wall surface.

5. The semiconductor device of any preceding claim, further comprising a package housing at least partially surrounding the semiconductor chip,
   wherein the package housing has a first opening configured to discharge the gaseous coolant from the cooling channel, and a second opening configured to supply the liquid coolant to the cooling channel.

6. The semiconductor device of claim 5, further comprising a supply channel provided on an upper surface of the semiconductor chip and connecting the second opening to the cooling channel.

7. The semiconductor device of claim 6, wherein the supply channel comprises a third fine pattern on the upper surface of the semiconductor chip and configured to generate a capillary force that moves the liquid coolant.

8. The semiconductor device of claim 5, 6 or 7, further comprising a plurality of cooling channels, including the cooling channel, provided in the semiconductor chip,
   wherein a plurality of first openings respectively corresponding to the plurality of cooling channels are provided in the package housing.

9. The semiconductor device of any preceding claim, further comprising a plurality of semiconductor chips stacked in a longitudinal direction and each including the cooling channel,
   wherein each of the plurality of semiconductor chips other than a lowest semiconductor chip of the plurality of semiconductor chips comprises a connection channel penetrating in the longitudinal direction.

10. The semiconductor device of claim 9, wherein the connection channel comprises a wall surface comprising a second fine pattern extending in the longitudinal direction.

11. The semiconductor device of claim 9 or 10, further comprising an outer cooling channel between two adjacent semiconductor chips of the plurality of semiconductor chips,
wherein a first fine pattern configured to generate a capillary force that moves the liquid coolant in a transverse direction is provided on at least a portion of a wall surface of the outer cooling channel in the transverse direction.

12. The semiconductor device of claim 11, wherein the first fine pattern is provided on an upper surface of a lower semiconductor chip of two adjacent semiconductor chips of the plurality of semiconductor chips.


**Patentansprüche**

1. Halbleiteranordnung (1), umfassend:

einen Halbleiterchip (100), der eine integrierte Halbleiterschaltung (120) umfasst; und
einen Kühlkanal (10), umfassend:

zumindest einen ersten Abschnitt, der innerhalb des Halbleiterchips ist;
eine Wandfläche, die ein feines Muster umfasst, das konfiguriert ist, um eine Kapillarkraft zu erzeugen, die bewirkt, dass ein flüssiges Kühlmittel in dem Kühlkanal fließt;
einen Flüssigkeitskanalbereich (11) in einem ersten Bereich des Kühlkanals, in dem das feine Muster (20) gebildet ist, und konfiguriert, um das flüssige Kühlmittel durchzulassen; und
einen Gaskanalbereich (12) in einem zweiten Bereich des Kühlkanals, in dem das feine Muster nicht gebildet ist, und konfiguriert, um ein gasförmiges Kühlmittel durchzulassen;
**dadurch gekennzeichnet, dass** die Wandfläche eine erste Wandfläche (201), die sich in einer Querrichtung in dem Kühlkanal erstreckt, und eine zweite Wandfläche (202), die sich in einer Längsrichtung von der ersten Wandfläche erstreckt, umfasst, und
wobei das feine Muster Folgendes umfasst:

ein erstes feines Muster (210), das auf der ersten Wandfläche gebildet ist, und
ein zweites feines Muster (220), das auf der zweiten Wandfläche gebildet ist.

2. Halbleiteranordnung nach Anspruch 1, wobei eine Gesamtheit des Kühlkanals innerhalb des Halbleiterchips gebildet ist.

3. Halbleiteranordnung nach Anspruch 1 oder 2, wobei der zumindest erste Abschnitt des Kühlkanals nach innen von einer oberen Fläche des Halbleiterchips gebildet ist.

4. Halbleiteranordnung nach Anspruch 1, wobei das erste feine Muster konfiguriert ist, um eine Kapillarkraft zu erzeugen, die das flüssige Kühlmittel in der Querrichtung entlang der ersten Wandfläche bewegt, und
wobei das zweite feine Muster konfiguriert ist, um eine Kapillarkraft zu erzeugen, die das flüssige Kühlmittel in der Längsrichtung entlang der zweiten Wandfläche und zu der ersten Wandfläche bewegt.

5. Halbleiteranordnung nach einem vorhergehenden Anspruch, ferner umfassend ein Verpackungsgehäuse, das den Halbleiterchip zumindest teilweise umgibt,
wobei das Verpackungsgehäuse eine erste Öffnung, die konfiguriert ist, um das gasförmige Kühlmittel aus dem Kühlkanal abzulassen, und eine zweite Öffnung, die konfiguriert ist, um das flüssige Kühlmittel dem Kühlkanal zuzuführen, aufweist.

6. Halbleiteranordnung nach Anspruch 5, ferner umfassend einen Zuführkanal, der auf einer oberen Fläche des Halbleiterchips bereitgestellt ist und die zweite Öffnung mit dem Kühlkanal verbindet.

7. Halbleiteranordnung nach Anspruch 6, wobei der Zuführkanal ein drittes feines Muster auf der oberen Fläche des Halbleiterchips umfasst und konfiguriert ist, um eine Kapillarkraft zu erzeugen, die das flüssige Kühlmittel bewegt.

8. Halbleiteranordnung nach Anspruch 5, 6 oder 7, ferner umfassend eine Vielzahl von Kühlkanälen, beinhaltend den Kühlkanal, die in dem Halbleiterchip bereitgestellt ist,

wobei eine Vielzahl von ersten Öffnungen, die jeweils der Vielzahl von Kühlkanälen entspricht, in dem Verpackungsgehäuse bereitgestellt ist.

9. Halbleiteranordnung nach einem vorhergehenden Anspruch, ferner umfassend eine Vielzahl von Halbleiterchips, die in einer Längsrichtung gestapelt ist und jeweils den Kühlkanal beinhaltet, wobei jeder aus der Vielzahl von Halbleiterchips, der sich von einem untersten Halbleiterchip aus der Vielzahl von Halbleiterchips unterscheidet, einen Verbindungskanal umfasst, der in der Längsrichtung eindringt.

10. Halbleiteranordnung nach Anspruch 9, wobei der Verbindungskanal eine Wandfläche umfasst, die ein zweites feines Muster umfasst, das sich in der Längsrichtung erstreckt.

11. Halbleiteranordnung nach Anspruch 9 oder 10, ferner umfassend einen äußeren Kühlkanal zwischen zwei benachbarten Halbleiterchips aus der Vielzahl von Halbleiterchips, wobei ein erstes feines Muster, das konfiguriert ist, um eine Kapillarkraft zu erzeugen, die das flüssige Kühlmittel in einer Querrichtung bewegt, an zumindest einem Abschnitt einer Wandfläche des äußeren Kühlkanals in der Querrichtung bereitgestellt ist.

12. Halbleiteranordnung nach Anspruch 11, wobei das erste feine Muster auf einer oberen Fläche eines unteren Halbleiterchips von zwei benachbarten Halbleiterchips aus der Vielzahl von Halbleiterchips bereitgestellt ist.

## Revendications

1. Dispositif semi-conducteur (1) comprenant :

   une puce semi-conductrice (100) comprenant un circuit intégré à semi-conducteur (120) ; et
   un canal de refroidissement (10) comprenant :

   au moins une première partie qui est à l'intérieur de la puce semi-conductrice ;
   une surface de paroi comprenant un motif fin conçu pour générer une force capillaire qui provoque l'écoulement d'un réfrigérant liquide dans le canal de refroidissement ;
   une zone de canal de liquide (11) dans une première zone du canal de refroidissement où le motif fin (20) est formé et conçue pour laisser passer le réfrigérant liquide ; et
   une zone de canal de gaz (12) dans une seconde zone du canal de refroidissement où le motif fin n'est pas formé et conçue pour laisser passer un réfrigérant liquide gazeux ;
   **caractérisé en ce que** la surface de paroi comprend une première surface de paroi (201) s'étendant dans une direction transversale dans le canal de refroidissement et une seconde surface de paroi (202) s'étendant dans une direction longitudinale à partir de la première surface de paroi, et
   dans lequel le motif fin comprend :

   un premier motif fin (210) formé sur la première surface de paroi, et
   un deuxième motif fin (220) formé sur la seconde surface de paroi.

2. Dispositif semi-conducteur selon la revendication 1, dans lequel une totalité du canal de refroidissement est formée à l'intérieur de la puce semi-conductrice.

3. Dispositif à semi-conducteur selon la revendication 1 ou 2, dans lequel l'au moins une première partie de canal de refroidissement est formée vers l'intérieur à partir d'une surface supérieure de la puce semi-conductrice.

4. Dispositif semi-conducteur selon la revendication 1, dans lequel le premier motif fin est conçu pour générer une force capillaire qui déplace le réfrigérant liquide dans la direction transversale le long de la première surface de paroi, et dans lequel le deuxième motif fin est configuré pour générer une force capillaire qui déplace le réfrigérant liquide dans la direction longitudinale le long de la seconde surface de paroi et vers la première surface de paroi.

5. Dispositif semi-conducteur selon l'une quelconque des revendications précédentes, comprenant en outre un boîtier d'encapsulation entourant au moins partiellement la puce semi-conductrice, dans lequel le boîtier d'encapsulation comporte une première ouverture conçue pour évacuer le réfrigérant gazeux du canal de refroidissement, et une seconde ouverture conçue pour délivrer le réfrigérant liquide au canal de refroidissement.

6. Dispositif semi-conducteur selon la revendication 5, comprenant en outre un canal d'alimentation prévu sur une surface supérieure de la puce semi-conductrice et connectant la seconde ouverture au canal de refroidissement.

7. Dispositif semi-conducteur selon la revendication 6, dans lequel le canal d'alimentation comprend un troisième motif fin sur la surface supérieure de la puce semi-conductrice et conçu pour générer une force capillaire qui déplace le réfrigérant liquide.

8. Dispositif semi-conducteur selon la revendication 5, 6 ou 7, comprenant en outre une pluralité de canaux de refroidissement, comprenant le canal de refroidissement, prévus dans la puce semi-conductrice, dans lequel une pluralité de premières ouvertures correspondant respectivement à la pluralité de canaux de refroidissement sont prévues dans le boîtier d'encapsulation.

9. Dispositif semi-conducteur selon l'une quelconque des revendications précédentes, comprenant en outre une pluralité de puces semi-conductrices empilées dans une direction longitudinale et comprenant chacune le canal de refroidissement, dans lequel chacune de la pluralité de puces semi-conductrices autre qu'une puce semi-conductrice la plus basse de la pluralité de puces semi-conductrices comprend un canal de connexion pénétrant dans la direction longitudinale.

10. Dispositif semi-conducteur selon la revendication 9, dans lequel le canal de connexion comprend une surface de paroi comprenant un deuxième motif fin s'étendant dans la direction longitudinale.

11. Dispositif semi-conducteur selon la revendication 9 ou 10, comprenant en outre un canal de refroidissement externe entre deux puces semi-conductrices adjacentes de la pluralité de puces semi-conductrices, dans lequel un premier motif fin conçu pour générer une force capillaire qui déplace le réfrigérant liquide dans une direction transversale est prévu sur au moins une partie d'une surface de paroi du canal de refroidissement externe dans la direction transversale.

12. Dispositif semi-conducteur selon la revendication 11, dans lequel le premier motif fin est prévu sur une surface supérieure d'une puce semi-conductrice plus basse entre deux puces semi-conductrices adjacentes de la pluralité de puces semi-conductrices.

# FIG. 1

# FIG. 2

# FIG. 3

# FIG. 4A

# FIG. 4B

# FIG. 4C

# FIG. 5A

# FIG. 5B

# FIG. 5C

# FIG. 5D

# FIG. 6

EP 4 386 832 B1

# FIG. 7

EP 4 386 832 B1

# FIG. 8

# FIG. 9

# FIG. 10

# FIG. 11

EP 4 386 832 B1

# FIG. 12

# FIG. 13

# FIG. 14

# FIG. 15A

# FIG. 15B

# FIG. 16

**REFERENCES CITED IN THE DESCRIPTION**

**Patent documents cited in the description**

- US 2005280162 A1
- US 2018294205 A1
- US 2010187683 A1
- US 2005139996 A1
- US 6698502 B1